# EUROPÄISCHE PATENTANMELDUNG

(11) **EP 3 875 641 A1**
(43) Veröffentlichungstag der Anmeldung: **08.09.2021**
(21) Anmeldenummer: 20172971.2
(22) Anmeldetag: 05.05.2020
(51) Int. Cl.: C25D 21/18, C25D 21/22, C25C 3/00, C25D 21/14, C25D 3/38

(54) **VERFAHREN ZUM AUFBEREITEN EINES METALLSALZ-HALTIGEN MEDIUMS AUS EINEM ÄTZPROZESS DER LEITERPLATTEN- UND/ODER SUBSTRAT-HERSTELLUNG**

(30) Priorität: 04.03.2020 EP 20160862
(71) Anmelder: AT & S Austria Technologie & Systemtechnik Aktiengesellschaft, 8700 Leoben-Hinterberg (AT)
(72) Erfinder: Klocek, Jolanta, 8712 Niklasdorf (AT); Payerl, Claudia, 8020 Graz (AT); Frey, Gerhard, 8793 Trofaiach (AT); Schrei, Martin, 8382 Mogersdorf (AT); Redl, Alois, 8712 Niklasdorf (AT); Ebinger, Christoph, 70599 Stuttgart (DE); Herzog, René, 8045 Graz (AT); Zanker, Andreas, 8753 Fohnsdorf (AT); Mandl, Thomas, 8720 Knittelfeld (AT); Gross, Friedrich, 8700 Leoben (AT); Kern, Konstantin, 8700 Leoben (AT); Moitzi, Heinz, 8740 Zeltweg (AT)
(74) Vertreter: Dilg, Haeusler, Schindelmann Patentanwaltsgesellschaft mbH

(57) **Zusammenfassung**

Es wird ein Verfahren (100) beschrieben zum Aufbereiten eines aufzubereitenden Mediums (11) aus der Leiterplatten- und/oder Substrat-Herstellung, insbesondere einem Ätzprozess (150), wobei das aufzubereitende Medium (11) ein aufzubereitendes Metallsalz und eine Säure (15) aufweist, das Verfahren aufweisend: i) mehrstufiges Entfernen (110, 120) der Säure (15) aus dem aufzubereitenden Medium (11) mittels Membrandialyse, um ein konzentriertes aufzubereitendes Medium (141) bereitzustellen, und nachfolgend ii) Durchführen einer chemischen Reaktion (140) zum Erzeugen eines Metallsalz-haltigen Mediums (10) aus dem konzentrierten aufzubereitenden Medium (141).

## Beschreibung

Die Erfindung betrifft ein Verfahren zum Aufbereiten eines aufzubereitenden Mediums aus der Leiterplatten- und/oder Substrat-Herstellung, insbesondere aus einem Ätzprozess. Weiterhin betrifft die Erfindung eine Vorrichtung, insbesondere eine Industrieanlage, zum Ausführen des Verfahrens. Ferner betrifft die Erfindung ein Verwenden einer chemischen Reaktion des Verfahrens. Außerdem betrifft die Erfindung eine Prozesskontrollvorrichtung zum Regulieren des Verfahrens und/oder der Vorrichtung. Weiterhin betrifft die Erfindung ein Computerprogramm-Produkt zum Steuern des Verfahrens und/oder der Vorrichtung und/oder der Prozesskontrollvorrichtung.

Die Erfindung kann sich somit auf das technische Gebiet der Leiterplatten- und/oder Substrat-Herstellung beziehen. Insbesondere kann sich die Erfindung auf das technische Gebiet des Aufbereitens von Metallsalz-haltigem Medium aus der Leiterplatten- und/oder Substrat-Herstellung beziehen. Weiter kann sich die Erfindung auf das technische Gebiet des Recycelns innerhalb der Leiterplatten- und/oder Substrat-Herstellung beziehen.

Für die Erzeugung von Leiterplatten und/oder Substraten werden prinzipiell große Mengen an Metallen, insbesondere Schwermetallen (z.B. Kupfer, Nickel, Gold, Silber, Palladium, Zinn, Eisen) benötigt. Innerhalb des Herstellungsprozesses fallen daher aus den unterschiedlichen Prozessen Metall-haltige Rückstände bzw. Metall-haltige Medien (insbesondere Lösungen) an.

Die aufzubereitenden Metall (-salz)-haltigen Medien (bzw. zu reinigenden Abfall- und Rückstandskonzentrate) stammen im Wesentlichen aus zwei unterschiedlichen Verarbeitungsprozessen bei der Leiterplatten- und/oder Substrat-Herstellung: i) dem Ätzprozess (z.B. Ätzen von Kupferfolien) und ii) dem Galvanikprozess (z.B. Galvanisieren mit Kupferschichten). Zudem fallen aufzubereitende Metall (-salz)-haltige Medien während Spülprozessen sowohl aus dem Ätzprozess als auch aus dem Galvanikprozess an. Diese Spülwässer enthalten nur geringe Konzentrationen an Metall, insbesondere Kupfer. Die aufzubereitenden Metall (-salz)-haltigen Medien aus den Ätzprozessen und den Galvanikprozessen weisen hingegen vergleichsweise hohe Konzentrationen an Metall auf. Ein aufzubereitendes Metall (-salz)-haltiges Medium aus dem Ätzprozess enthält gewöhnlich ein Metallsalz, in welchem das Metall mit dem Salz einer Säure (von dem Ätzvorgang) chemisch verbunden vorliegt (beispielsweise Kupferchlorid, wobei das Chlorid aus Salzsäure stammt).

Es sind zwar prinzipiell Methoden bekannt, Metall aus den beschriebenen Metall (-salz)-haltigen Medien rückzugewinnen. Allerdings ist ein rückgewonnenes Metall für die Leiterplatten- und/oder Substrat-Herstellung nur in hochreiner Form (z.B. 99% bis 99,99%, insbesondere etwa 99,9% rein) von Interesse. Eine solche Rückgewinnung kann z.B. mittels einer Elektrolyse erfolgen. Die oben beschriebenen Metall (-salz)-haltigen Medien sind hierfür allerdings denkbar ungeeignet, denn die Abscheidung von reinem Metall (z.B. Kupfer) ist durch die Zusammensetzung der Metall (-salz)-haltigen Medien behindert und/oder erschwert. So kann das Salz einer Säure aus dem Ätzprozess in der Rückgewinnung zur Entstehung gefährlicher Gase führen (z.B. Chlorgas im Fall von Salzsäure).

Aus diesem Grund werden konventionell Abfallkonzentrate aus der Leiterplatten- und/oder Substrat-Herstellung auf kostenintensive und wenig umweltfreundliche bzw. nachhaltige Weise entsorgt.

Es ist eine Aufgabe der vorliegenden Erfindung ein kostengünstiges, umweltfreundliches, und nachhaltiges Aufbereiten eines Metallsalz-haltigen Mediums aus (einem Ätzprozess) der Leiterplatten- und/oder SubstratHerstellung innerhalb eines Wertstoffkreislaufs (Prozess-internes, bevorzugt kontinuierliches, Recycling) auf effiziente und robuste Weise zu ermöglichen.

Gemäß einem Aspekt der Erfindung wird ein Verfahren beschrieben zum Aufbereiten eines aufzubereitenden Mediums (z.B. ein Metallsalz, wie Kupferchlorit -haltiges Medium, welches aufbereitet werden soll, um ein weiteres Metallsalz (z.B. Kupfersulfat) -haltiges Medium bereitzustellen) aus der Leiterplatten- und/oder Substrat-Herstellung, insbesondere einem Ätzprozess (bzw. einem Prozess, welcher das Ätzen (z.B. mittels Salzsäure) von Metall umfasst), wobei das aufzubereitende Medium ein aufzubereitendes Metallsalz (z.B. Kupferchlorid) und eine Säure (z.B. Salzsäure) aufweist. Das Verfahren aufweisend: i) mehrstufiges (z.B. zwei oder mehr Stufen) Entfernen der Säure aus dem aufzubereitenden Medium mittels Membrandialyse bzw. Säuredialyse), um ein (an Metallsalz) konzentriertes aufzubereitendes Medium (z.B. Kupferchlorid in hoher Konzentration und wenig Säure aufweisend) bereitzustellen, und nachfolgend ii) Durchführen einer chemischen Reaktion (z.B. Umsalzen, insbesondere unter Verwenden einer weiteren Membrandialyse) zum Erzeugen eines Metallsalz-haltigen Mediums (z.B. Kupfersulfat aufweisend) aus dem konzentrierten aufzubereitenden Medium.

Gemäß einem weiteren Aspekt der Erfindung wird eine Vorrichtung zum Aufbereiten eines aufzubereitenden Mediums aus einem Ätzprozess aus der Leiterplatten- und/oder Substrat-Herstellung beschrieben. Das aufzubereitende Medium weist ein aufzubereitendes Metallsalz (z.B. Kupferchlorid) und eine Säure (z.B. Salzsäure) auf. Die Vorrichtung aufweisend: i) ein erstes Membrandialyse Modul und in Prozessrichtung nachfolgend ein zweites Membrandialyse Modul zum Entfernen der Säure aus dem aufzubereitenden Medium mittels Membrandialyse, um ein konzentriertes aufzubereitendes Medium bereitzustellen, und in Prozessrichtung nachfolgend ii) einen Reaktor zum Durchführen einer chemischen Reaktion, um ein Metallsalz-haltigen Mediums aus dem konzentrierten aufzubereitenden Medium zu erzeugen.

Gemäß einem weiteren Aspekt der Erfindung wird ein Verwenden beschrieben der exothermen chemischen Reaktion von einem Metallchlorid zu einem Metallsulfat oder Metallnitrat oder Metallphosphat zum Erwärmen eines flüssigen Mediums innerhalb einer (bzw. der) Leiterplatten- und/oder Substrat-Herstellung.

Gemäß einem weiteren Aspekt der vorliegenden Erfindung wird eine Prozesskontrollvorrichtung zum Regulieren des oben beschriebenen Verfahrens und/oder der oben beschriebenen Vorrichtung diskutiert. Die Prozesskontrollvorrichtung weist auf: i) eine Datenbank zum Erfassen von zumindest einem Prozessparameter (bzw. einem Ist-Wert), insbesondere einer Mehrzahl von Prozessparametern, aus dem laufenden Prozess, ii) eine Datenmodell-Einheit, welche eingerichtet ist zum Speichern von zumindest einem vorbestimmten Prozessparameter (bzw. einem Soll-Wert), insbesondere einer Mehrzahl von vorbestimmten Prozessparametern, und iii) eine Berechnungsvorrichtung, welche eingerichtet ist zum a) Vergleichen des erfassten Prozessparameters mit dem vorbestimmten Prozessparameter (bzw. der Mehrzahlen miteinander), b) Bestimmen einer Steueroperation, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation (z.B. Flussrate anpassen, etc...).

Gemäß einem weiteren Aspekt der vorliegenden Erfindung wird ein Computerprogramm-Produkt beschrieben zum Steuern eines Verfahrens zum Aufbereiten eines Fremdmetall- und Metallsalz-haltigen Mediums aus der Leiterplatten und/oder Substrat Herstellung, welches Computerprogramm-Produkt, wenn es von einem oder mehreren Prozessoren (bzw. einem oder mehreren Computern) ausgeführt wird, das Verfahren (wie oben beschrieben) und/oder die Vorrichtung (wie oben beschrieben) und/oder die Prozesskontrollvorrichtung (wie oben beschrieben) steuert.

Im Rahmen dieses Dokuments kann unter dem Begriff "Metallsalz-haltiges Medium" insbesondere jegliches (flüssige) Medium verstanden werden, welches ein Metallsalz aufweist. Ein Metallsalz ist eine chemische Verbindung zwischen einem Metall und einer Säure. Beispiele für ein solches Metall können umfassen: Kupfer, Nickel, Gold, Silber, Cobalt, Cadmium, Magnesium, Natrium, Palladium, Zinn. Beispiele für Säuren können umfassen: Schwefelsäure, Salzsäure, Salpetersäure, Phosphorsäure; wobei das Metallsalz entsprechend z.B. als Sulfat, Chlorid, Nitrat, oder Phosphat vorliegt. Entsprechend kann ein Metallsalz z.B. Kupfersulfat oder Kupferchlorid sein. Dieses kann in dem Metallsalz-haltigen Medium als Metall-Ion und Salz-Ion vorliegen. Ein Metallsalz-haltiges Medium kann neben Metallsalz eine Lösung aufweisen, welche z.B. wässrig oder sauer sein kann, in welcher das Metallsalz gelöst ist. Beispielsweise kann das Medium neben Wasser auch Salzsäure und/oder Schwefelsäure aufweisen. In einem Beispiel stammt das Metallsalz-haltige Medium aus der Herstellung von Leiterplatten und/oder Substraten und kann entsprechende Rückstände aufweisen. Ferner kann das Metallsalz-haltige Medium aufbereitet sein, so dass im Wesentlichen nur das Metallsalz vorliegt. In einem Beispiel ist das Metallsalz-haltige Medium (im Wesentlichen) frei von (unerwünschtem) Fremdmetall (wie z.B. Eisen). In einem weiteren Beispiel weist das Metallsalz-haltige Medium (Reste von) Fremdmetall auf.

Im Rahmen dieses Dokuments kann unter dem Begriff "Leiterplatten- und/oder Substrat-Herstellung" insbesondere ein Prozess verstanden werden zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Eine Leiterplatten- und/oder Substrat-Herstellung umfasst gewöhnlich einen Ätzprozess, in welchem Metall mittels Ätzens derart entfernt wird, dass erwünschte Metallstrukturen erhalten werden, und einen Galvanisierungsprozess, in welchem Metall mittels Galvanisierens (plating) aufgetragen wird. Ausgangsmaterial für eine Leiterplatten- und/oder Substrat-Herstellung umfasst im Wesentlichen das Metall sowie elektrisch isolierendes Material, meist ein organisches Material wie ein Harz. Das Produkt des Prozesses kann die fertige Leiterplatte bzw. das Substrat sein, oder auch ein Zwischenprodukt.

In diesem Dokument kann unter dem Begriff "Ätzprozess" insbesondere ein Prozess der Leiterplatten- und/oder Substrat-Herstellung bezeichnet werden, welcher das Ätzen von Metall, insbesondere Kupfer, aufweist, um dadurch eine erwünschte metallische (elektrisch leitfähige) Struktur bereitzustellen. Gemäß einem exemplarischen Ausführungsbeispiel kann dieser Prozess wie folgt durchgeführt werden: ein Fotolack schützt Kupferpfade, die nicht weggeätzt werden sollen, während Kupferflächen, welche weggeätzt werden sollen, nicht mit dem Fotolack bedeckt sind. Zunächst wird hierzu die gesamte Kupferlage mit Fotolack überzogen. Dann wird durch eine Maske hinweg der Fotolack mittels UV-Licht entwickelt. Die Maske lässt nur an Stellen UV-Licht durch, an welchen der Fotolack bestehen bleiben soll (i.e. wo die erwünschten Leiterzüge bereitgestellt werden sollen). Während des Entwickelns vernetzt der Lack (bzw. das Polymer) an diesen Stellen, die mit UV-Licht belichtet wurden. Nach dem Entwickeln kann der Fotolack, welcher nicht belichtet wurde (bzw. nicht entwickelt wurde) einfach herunter gewaschen werden. Anschließend wird das Panel (bzw. die Komponententräger Vorform) geätzt. Der Fotolack schützt dabei die Leiterzüge während das Kupfer, welches nicht mit Fotolack bedeckt ist, geätzt/entfernt wird. Wenn der Ätzvorgang vorüber ist, wird der Fotolack entfernt bzw. abgezogen (der Lack ist vernetzt und fest) und die Leiterbahnen bleiben übrig. Der gestrippte Fotolack kann zu einem späteren Zeitpunkt mittels Eisenchlorid gefällt werden.

Im Rahmen dieses Dokuments kann unter dem Begriff "Aufbereiten" insbesondere verstanden werden, dass ein aufzubereitendes Medium (insbesondere in ein Medium mit zumindest einer unerwünschten Eigenschaft bzw. Substanz) innerhalb von ein oder mehr Prozessschritten derart bearbeitet wird, dass ein aufbereitetes Medium (insbesondere einem Medium, welches die unerwünschte Eigenschaft/Substanz im Wesentlichen nicht mehr aufweist) vorliegt. Beispielsweise kann ein aufzubereitendes Medium ein Metallsalz-haltiges Medium sein, bei welchem zumindest ein Metallsalz unerwünscht ist. Entsprechend kann das aufzubereitende Medium derart aufbereitet werden (z.B. mittels Membrandialyse und dem Durchführen einer chemischen Reaktion), dass als aufbereitetes Medium ein Metallsalz-haltiges Medium vorliegt, welches das unerwünschte Metallsalz (im Wesentlichen) nicht mehr aufweist.

Im Rahmen dieses Dokuments kann unter dem Begriff "Dialyse" insbesondere verstanden werden, dass ein konzentrationsgetriebener Membranprozess verwendet wird, um Moleküle (insbesondere Ionen) aus Lösungen zu entfernen. In einem Ausführungsbeispiel wird ein Metallsalz-haltiges Medium über einen ersten Zulauf (Dialysat Zulauf) an eine erste Seite der Membran bereitgestellt und über einen zweiten Zulauf (Diffusat Zulauf) wird ein weiteres Medium (z.B. Wasser) an der zweiten (der ersten gegenüberliegenden) Seite der Membran bereitgestellt. Die Membran kann semipermeabel sein und lässt Anionen (z.B. Chlorid) passieren (Anionen-Membran), während Kationen (z.B. Cu²⁺) nicht passieren können. Somit konzentrieren sich Kationen in dem Metallsalz-haltigen Medium als Dialysat, während sich Anionen in dem weiteren Medium als Diffusat konzentrieren. In dem Beispiel von Chlorid-Anionen wird das Diffusat stark sauer, so dass auch der Begriff "Säuredialyse" verwendet werden kann.

Es kann für die im Folgenden beschriebenen Membrandialysen jeweils dieselbe Membran eingesetzt werden oder (bevorzugt) werden unterschiedliche Membranen verwendet. Eine Anionen-Membran kann z.B. mit Brom (Br⁻) funktionalisiert sein, wobei das Trägermaterial beispielsweise PET oder PVC sein kann. In bestimmten Fällen kann die Metallsalz-haltige Lösung Wasserstoffperoxid (H₂O₂) beinhalten. In diesem Fall kann bevorzugt eine oxidationsbeständige Membran genutzt werden, welche z.B. auf PEEK (Polyetheretherketon-Trägermaterial) basiert.

Im Rahmen dieses Dokuments kann unter dem Begriff "Prozesskontrollvorrichtung" insbesondere jegliche Vorrichtung (oder Mehrzahl an Vorrichtungen) verstanden werden, welche geeignet ist eine Prozesskontrolle vorzunehmen, wobei der Prozess (zumindest teilweise) eine Leiterplatten- und/oder Substrat-Herstellung betrifft. Insbesondere ist die Prozesskontrollvorrichtung eingerichtet (zumindest teilweise) einen Wertstoffkreislauf zu steuern bzw. zu regeln, bei welchem Rückstände der Produktion derart rückgeführt werden, dass im Wesentlichen keine (Schwermetall und/oder Säure) Abfälle anfallen. Die Prozesskontrollvorrichtung kann hierfür insbesondere eine Datenbank (-Einheit) und eine Datenmodell-Einheit aufweisen, wobei erstere ermittelte Prozessdaten speichert, während letztere vorgesehene erwünschte Prozessdaten speichert. Die Prozesskontrollvorrichtung kann mit einer Vielzahl von Sensoren bzw. Messgeräten gekoppelt sein, um auf diese Weise an verschiedenen Prozessstationen aktuelle Parameter zu bestimmen. Ferner kann die Prozesskontrollvorrichtung eine Berechnungsvorrichtung aufweisen, welche die ermittelten Parameter mit den erwünschten vergleicht und basierend hierauf eine Steueroperation bestimmt und durchführt. In einem bevorzugten Ausführungsbeispiel weist die Prozesskontrollvorrichtung einen selbstlernenden Algorithmus (AI) auf, mittels welchem das Steuern bzw. das Regeln des Prozesses stetig verbessert werden kann.

Im Rahmen dieses Dokuments kann der Begriff "im Wesentlichen" derart ausgelegt werden, dass vernachlässigbare Rückstände bzw. Verschmutzungen umfasst sein können, welche nicht mehr über vertretbaren Aufwand entfernbar sind. Diese vernachlässigbaren Rückstände bzw. Verschmutzungen sind in einem Ausführungsbeispiel (bewusst) nicht erwünscht, lassen sich aber auch mit vernünftigem Aufwand nicht mehr entfernen. Beispielsweise kann ein Medium in Einleitqualität im Wesentlichen frei von Schwermetall sein, was derart verstanden werden soll, dass vernachlässigbare Rückstände bzw. Verschmutzungen (z.B. im unteren Prozent-, Promille-, oder sogar ppm-Bereich) vorhanden sein können. Der Fachmann versteht, dass, obwohl diese Rückstände bzw. Verschmutzungen nicht erwünscht sind, sie aber nicht mehr auf Aufwand-technisch vertretbare Weise separiert werden können.

Im Kontext des vorliegenden Dokuments kann der Begriff "(gedruckte) Leiterplatte" (PCB) insbesondere einen im Wesentlichen plattenförmigen Komponententräger (dieser kann flexibel, rigide, oder semi-flexibel sein) bezeichnen, welcher gebildet wird, indem mehrere elektrisch leitfähige Schichtstrukturen mit mehreren elektrisch isolierenden Schichtstrukturen laminiert werden, beispielsweise indem Druck angelegt wird und/oder indem thermische Energie zugeführt wird. Als bevorzugte Materialien für die PCB Technologie sind die elektrisch leitfähigen Schichtstrukturen aus Kupfer, wohingegen die elektrisch isolierenden Schichtstrukturen Harz und/oder Glasfasern aufweisen können, sogenanntes Prepreg oder FR4 Material. Die verschiedenen elektrisch leitfähigen Schichtstrukturen können miteinander auf gewünschte Weise verbunden werden, indem Durchgangsöffnungen durch das Laminat gebildet werden, beispielsweise mittels Laserbohrens oder mechanischen Bohrens, und indem diese mit elektrisch leitfähigem Material (insbesondere Kupfer) gefüllt werden, wobei dadurch Vias als Durchgangsöffnung Verbindungen gebildet werden. Neben einer oder mehreren Komponenten, welche in eine gedruckte Leiterplatte eingebettet sein können, ist eine gedruckte Leiterplatte typischerweise konfiguriert zum Aufnehmen von einer oder mehreren Komponenten auf einer oder beiden entgegengesetzten Oberflächen der plattenförmigen gedruckten Leiterplatte. Sie können mit der entsprechenden Hauptoberfläche mittels Lötens verbunden werden. Auch können diese Komponenten eingebettet werden. Ein dielektrischer Teil einer PCB kann Harz mit verstärkenden Strukturen (beispielsweise Glasfasern oder Glaskugeln) umfassen.

Im Kontext des vorliegenden Dokuments kann der Begriff "Substrat" insbesondere einen kleinen Komponententräger bezeichnen, welcher im Wesentlichen dieselbe Größe wie eine Komponente hat (insbesondere einer elektronischen Komponente), welche darauf zu montieren ist (wie bei einem Chip Scale Package (CSP)). Insbesondere kann unter einem Substrat ein Träger für elektrische Verbindungen oder elektrische Netzwerke oder auch ein Komponententräger verstanden werden, welcher mit einer gedruckten Leiterplatte (PCB) vergleichbar ist, allerdings mit einer beträchtlich höheren Dichte von seitlich und/oder vertikal angeordneten Verbindungen. Seitliche Verbindungen sind beispielsweise leitfähige Pfade, wohingegen vertikale Verbindungen beispielsweise Bohrlöcher sein können. Diese seitlichen und/oder vertikalen Verbindungen sind in dem Substrat angeordnet und können verwendet werden, um elektrische und/oder mechanische Verbindungen von gehäusten Komponenten oder ungehäusten Komponenten (beispielsweise Dies) bereitzustellen, insbesondere von IC Chips mit einer gedruckten Leiterplatte oder einer Zwischen-gedruckten Leiterplatte. Somit enthält der Begriff "Substrat" auch "IC Substrate". Ein dielektrischer Teil eines Substrats kann Harz mit verstärkenden Partikeln (beispielsweise verstärkende Kugeln, insbesondere Glaskugeln) umfassen.

Das Substrat oder der Interposer kann aus zumindest einer Glas-Schicht (Silizium (Si)) oder einer fotostrukturierbaren, oder einer trockenätzbaren organischen Schicht bestehen. Als organisches Material/organische Schicht kann beispielsweise ein Epoxid-basiertes Aufbaumaterial (beispielsweise Epoxidbasierter Aufbaufolie) oder Polymerverbindungen wie Polyimid, Polybenzoxazol oder Benzocyclobuten-funktionalisierten Polymeren herangezogen werden.

In einer Ausführungsform ist der Komponententräger ein Laminat-Typ Komponententräger. In einer derartigen Ausführungsform ist der Komponententräger ein Verbund aus mehreren Schichtstrukturen, welche gestapelt sind und miteinander verbunden sind, indem eine Presskraft und/oder Wärme aufgebracht wird.

In einer Ausführungsform weist zumindest eine der elektrisch leitfähigen Schichtstrukturen zumindest eines aus der Gruppe auf bestehend aus Kupfer, Aluminium, Nickel, Silber, Gold, Palladium, Magnesium, und Wolfram. Obwohl Kupfer typischerweise bevorzugt ist, sind auch andere Materialien oder beschichtete Versionen davon möglich, insbesondere beschichtet mit einem supra-leitfähigen Material wie beispielsweise Graphen.

In diesem Dokument kann unter dem Begriff "Schwermetall" insbesondere ein Metall verstanden werden, welches eine Dichte größer als 5,0 g/cm³ (alternativ größer als 4,5 g/cm³) aufweist. Hierzu zählen z.B. Kupfer, Nickel, Cobalt, Gold, Silber, Palladium, Wolfram, Zinn, Zink, Eisen, Blei, Chrom, Rhodium, Cadmium, etc. Nicht als Schwermetall bezeichnet werden nach dieser Definition z.B. Aluminium, Silizium, Natrium, Kalium, Calcium, Magnesium, etc.

Gemäß einem exemplarischen Ausführungsbeispiel kann die Erfindung auf der Idee basieren, dass ein kostengünstiges, umweltfreundliches, und nachhaltiges Aufbereiten eines (Abfall-) Mediums (welches insbesondere ein aufzubereitendes Metallsalz und Säure aufweist) aus einem Ätzprozess der Leiterplatten- und/oder Substrat-Herstellung auf effiziente und robuste Weise (innerhalb eines Wertstoffkreislaufs) ermöglicht ist, wenn das aufzubereitende Medium zunächst einer mehrstufigen Membrandialyse zugeführt wird und dann einer chemischen Reaktion (wie Umsalzen) unterzogen wird.

Konventionell werden Abfall-Medien aus Ätzprozessen auf kostenintensive und wenig umweltfreundliche bzw. nachhaltige Weise entsorgt. Gemäß einem exemplarischen Beispiel fällt aus dem Ätzprozess als aufzubereitendes Medium Kupfer in Form von Kupferchlorid (als aufzubereitendes Metallsalz) und Salzsäure als Säure an. Der hohe Anteil an Chlorid-Ionen begünstigt während eines Rückgewinnes, z.B. einer Elektrolyse, die unkontrollierbare Bildung von Chlorgas. Zusätzlich können sich Chlorid-Ionen an der Elektrolyse-Elektrode mit abscheiden, wodurch die Reinheit des abgeschiedenen Kupfers negativ beeinflusst wird.

Es wurde nun aber überraschend erkannt, dass ein wirtschaftliches Aufbereiten von aufzubereitendem Medium und daraus folgendes Rückgewinnen von elementarem Metall aus einem Ätzprozess ermöglicht ist. Gerade das Durchführen mehrerer Säuredialyse-Stufen (besonders bevorzugt genau zwei) hat sich als besonders vorteilhaft erwiesen, um sowohl eine hohe Metall-Ausbeute zu erreichen und gleichzeitig möglichst wenig Flüssig-Medium und Kosten zu verursachen. Ferner hat sich überraschend gezeigt, dass die chemische Reaktion (besonders vorteilhaft in Kombination mit einer weiteren Membrandialyse) das entsprechend konzentrierte Medium effizient in eine Form überführen kann, welche direkt einem Rückgewinnen des elementaren Metalls zugeführt werden kann. Dieser hoch-effiziente Aufbereitungsprozess kann direkt in eine laufende Leiterplatten- und/oder Substrat Herstellung implementiert werden, so dass Abfälle aus dem Ätzprozess (Metallsalze und Säuren) nicht mehr Kosten-intensiv entsorgt werden müssen, sondern direkt in einem Wertstoffkreislauf gehalten werden können, mittels welchem sowohl Metall als auch Säure (kontinuierlich) in den(-selben) Herstellungsprozess rückgeführt werden können.

Gemäß einem Ausführungsbeispiel weisen das Metallsalz (des Metallsalz-haltigen Mediums) und das aufzubereitende Metallsalz (des aufzubereitenden Mediums) zumindest ein Metall aus der Gruppe auf, welche besteht aus: Kupfer, Nickel, Cobalt, Zinn, Cadmium, Magnesium, Natrium, Silber, Gold. Dies hat den Vorteil, dass elementare Ausgangsstoffe der Leiterplatten- und/oder Substratherstellung auf effiziente Weise rückgewonnen werden können und entsprechend in einem (im Wesentlichen) geschlossenen Kreislauf verbleiben.

Gemäß einem weiteren Ausführungsbeispiel weist das aufzubereitende Metallsalz ein Metallchlorid (insbesondere Kupferchlorid, CuCl₂) auf. Dies kann den Vorteil haben, dass ein Abfallstoff, welcher in großen Mengen im Ätzprozess anfällt, auf besonders effiziente Weise abgetrennt und sogar wiederverwendet werden kann.

Gemäß einem weiteren Ausführungsbeispiel weist das Metallsalz ein Metallsulfat (insbesondere Kupfersulfat, CuSO₄) auf. Dies kann den Vorteil haben, dass ein Massenprodukt (Metallsulfat) der Leiterplatten-/Substrat-Herstellung (insbesondere Galvanisierung und/oder Ätzprozess) (im Wesentlichen) vollständig recycelt bzw. innerhalb desselben Prozesses rückgeführt werden kann.

Gemäß einem weiteren Ausführungsbeispiel weist die Säure Salzsäure, HCl, auf. Dies kann den Vorteil haben, dass ein Abfallstoff, welcher in großen Mengen im Ätzprozess anfällt, auf besonders effiziente Weise abgetrennt und sogar wiederverwendet werden kann.

Gemäß einem weiteren Ausführungsbeispiel weist die chemische Reaktion ein Umsalzen auf. Insbesondere weist das Umsalzen ein Umwandeln des aufzubereitenden Metallsalzes in das (aufbereitete) Metallsalz mittels Zugebens einer weiteren Säure auf. Weiter insbesondere weist die weitere Säure zumindest eine aus der Gruppe auf, welche besteht aus: Schwefelsäure (H₂SO₄), Salzsäure (HCl), Salpetersäure (HNO₃), Phosphorsäure (H₃PO₄). Dies kann den Vorteil haben, dass auf flexible Weise eine Vielzahl aufzubereitender Metallsalze Prozess-intern in erwünschte Metallsalze umgewandelt werden können.

Bei dem Umsalzen kommt es zur Erzeugung von Säure (insbesondere Salzsäure) in dem nun vorliegenden Metallsalz-haltigen Medium. In einem exemplarischen Ausführungsbeispiel reagieren Kupferchlorid (als aufzubereitendes Metallsalz) und Schwefelsäure (als weitere Säure) aus dem Ätzprozess zu Kupfersulfat (Metallsalz) und Salzsäure. Sowohl ein Entfernen der Salzsäure als auch zumindest ein Teil der chemischen Reaktion werden mittels einer weiteren/dritten Membrandialyse durchgeführt.

Neben der Reaktion Kupferchlorid zu Kupfersulfat können beispielsweise auch folgende Umsalz-Reaktionen (jeweils mit den entsprechenden Säuren) stattfinden:

NiCl₂ + H₂SO₄ ↔ NiSO₄ + 2 HCl

NiCl₂ + 2 HNO₃ ↔ Ni(NO₃)₂ + 2 HCl

CoCl₂ + H₂SO₄ ↔ CoSO₄ + 2 HCl

CoCl₂+ 2 HNO₃ ↔ Co(NO₃)₂ + 2 HCl

3 CoCl₂ + 2 H₃PO₄ ↔ Co₃(PO₄)₂ + 6 HCl

SnCl₂ + H₂SO₄ ↔ SnSO₄ + 2 HCl

SnCl₂ + 2 HNO₃ ↔ Sn(NO₃)₂ + 2 HCl

CdCl₂ + H₂SO₄ ↔ CdSO₄ + 2 HCl

CdCl₂ + 2 HNO₃ ↔ Cd(NO₃)₂ + 2 HCl

3 CdCl₂ + 2 H₃PO₄ ↔ Cd₃(PO₄)₂ +6 HCl

MgCl₂ + H₂SO₄ ↔ MgSO₄ + 2 HCl

MgCl₂ + 2 HNO₃ ↔ Mg(NO₃)₂ + 2 HCl

3 MgCl₂ + 2 H₃PO₄ ↔ Mg₃(PO₄)₂ + 6 HCl

2 NaCI + H₂SO₄ ↔ Na₂SO₄ + 2 HCl

NaCI + HNO₃ ↔ NaNO₃ + HCl

3 NaCI + H₃PO₄ ↔ Na₃PO₄ + 3 HCl

Der Doppelpfeil stellt dabei die Gelichgewichtsreaktion dar. Prinzipiell kann auch von der Produkt-Seite ausgegangen und mit HCl umgesalzt werden, z.B. wie folgt:

NiSO₄ + 2 HCl ↔ NiCl₂ + H₂SO₄

Wird die Säure während der Entstehung entfernt, kann das Gleichgewicht auf die Seite der Produkte geschoben werden, so dass aus einem Doppelpfeil ein Pfeil wird, z.B. wie folgt:

NiSO₄ + 2 HCl → NiCl₂ + H₂SO₄.

Gemäß einem weiteren Ausführungsbeispiel ist die chemische Reaktion eine exotherme Reaktion und das Verfahren weist ferner auf: Ableiten von (zumindest einem Teil) der Reaktionswärme derart, dass ein flüssiges Medium (insbesondere ein flüssiges Medium in einem Versorgungsbecken oder Elektrolysebecken) innerhalb derselben Leiterplatten- und/oder Substrat-Herstellung erwärmt wird. Dies kann den besonderen Vorteil bereitstellen, dass für den Leiterplatten- und/oder Substrat-Herstellungsprozess benötigte Energie direkt Prozess-intern produziert und bereitgestellt werden kann.

In einem Ausführungsbeispiel hat es sich herausgestellt, dass die oben beschriebene chemische Reaktion (insbesondere Kupferchlorid zu Kupfersulfat) stark exotherm ist, so dass dadurch entstehende Abwärme zusätzlich als Energiequelle genutzt werden kann. In einem exemplarischen Beispiel können auf diese Weise 800 kW pro Tag durch die chemische (exotherme) Reaktion bereitgestellt werden. Diese Energie kann wiederum direkt eingesetzt (abgeleitet bzw. umgeleitet) werden, um ein flüssiges Medium (z.B. in einem Versorgungsbecken oder einem Elektrolysebecken einer Reaktionszelle) innerhalb ein und desselben Leiterplatten- und/oder Substrat-Herstellungsprozesses zu erwärmen/heizen. Überraschenderweise hat sich also gezeigt, dass dem Wertstoffkreislauf weniger Energie hinzugeführt werden muss, weil eine exotherme, Prozess-interne Reaktion als effiziente Energiequelle verwendet werden kann.

Gemäß einem weiteren Ausführungsbeispiel weist das mehrstufige Entfernen genau zwei Stufen (insbesondere genau zwei Membrandialyse Stufen) auf. Dies kann den Vorteil haben, dass ein Optimum bereitgestellt wird zwischen minimalen Aufwendungen und maximaler Ausbeute.

Gemäß einem weiteren Ausführungsbeispiel weist das Verfahren auf: i) Vorgeben eines Maximalwerts für das Volumen des Diffusats-Zulaufs der Membrandialyse, ii) Vorgeben eines Minimalwerts für die Konzentration an aufzubereitendem Metallsalz, und iii) Steuern der Prozessparameter derart, dass der vorgegebene Maximalwert nicht überschritten wird und der vorgegebene Minimalwert nicht unterschritten wird. Dies kann den Vorteil haben, dass hohe Konzentrationen des Metallsalzes erreicht werden während zugleich die Menge an eingesetzter Flüssigkeit nicht zu hoch wird.

In einem Beispiel führt dies in besonders vorteilhafter Weise dazu, dass keine unnötig großen Mengen an flüssigem Medium (bzw. Wasser und Säure) anfallen, sondern immer mit höchstmöglichen Konzentrationen an Metallsalz gearbeitet wird. Daher kann es sich anbieten, lediglich genau zwei Membrandialyse-Stufen durchzuführen, wodurch eine optimale Ausbeute bereitgestellt wird ohne, dass große Mengen an flüssigem Medium bei drei oder mehr Dialysen anfallen.

Gemäß einem weiteren Ausführungsbeispiel weist das Entfernen ferner auf: i) Entfernen von einem ersten Teil der Säure aus dem aufzubereitenden Medium mittels einer ersten Membrandialyse, um ein erstes Dialysat mit einer ersten Konzentration des aufzubereitenden Metallsalzes und ein erstes Diffusat, welches den ersten Teil der Säure aufweist, mit einer zweiten Konzentration des aufzubereitenden Metallsalzes zu erhalten, und nachfolgend ii) Entfernen von einem zweiten Teil der Säure aus dem ersten Diffusat mittels einer zweiten Membrandialyse, um ein zweites Dialysat mit einer dritten Konzentration des aufzubereitenden Metallsalzes und ein zweites Diffusat, welches den zweiten Teil der Säure aufweist, mit einer vierten Konzentration des aufzubereitenden Metallsalzes zu erhalten.

Gemäß einem weiteren Ausführungsbeispiel ist die erste Konzentration gleich oder größer als die zweite Konzentration, ist die dritte Konzentration größer ist als die vierte Konzentration, und ist die dritte Konzentration gleich oder kleiner ist als die zweite Konzentration. Auch dies kann den Vorteil haben, dass hohe Konzentrationen des Metallsalzes erreicht werden während zugleich die Menge an eingesetzter Flüssigkeit nicht zu hoch wird.

Es hat sich überraschend herausgestellt, dass nach einer ersten Membrandialyse das erste Diffusat immer noch eine beachtliche Konzentration des aufzubereitenden Metallsalzes aufweist. Derzeit wird vermutet, dass dies daran liegt, dass doch einige Kationen die Membran passieren, insbesondere wenn die Kationen mit den Anionen einen Komplex bzw. ein Aggregat (z.B. einen Kupfer-Chlor Komplex) bilden. Ohne an eine bestimmte Theorie gebunden sein zu wollen, wird derzeit davon ausgegangen, dass eine solche Aggregat-Bildung stattfinden kann, wenn die Konzentration der Kationen in einer Lösung erhöht ist. Die Konzentration an Kationen des aufzubereitenden Metallsalzes in dem ersten Diffusat ist aber deutlich geringer als die Kationen-Konzentration in dem ersten Dialysat-Zulauf. Daher wird davon ausgegangen, dass sich nun bei einer zweiten Membrandialyse (mit dem ersten Diffusat als zweitem Dialysat Zulauf) im Wesentlichen keine Aggregate mehr bilden, und nur noch eine vernachlässigbare Menge an Kationen durch die Membran diffundiert. Aus diesem Grund werden vorzugsweise genau zwei Membrandialyse-Stufen durchgeführt. Dadurch kann in vorteilhafter Weise eine hohe Konzentration des Metallsalzes erreicht werden, während zugleich die Menge an eingesetzter Flüssigkeit nicht zu hoch wird.

Gemäß einem weiteren Ausführungsbeispiel weist das Entfernen weiterhin auf: Bereitstellen des zweiten Diffusats (insbesondere welches die Säure aufweist) an einen Ätzprozess bei der Leiterplatten- und/oder Substrat-Herstellung. Hierbei wird insbesondere das zweite Diffusat zunächst aufbereitet. Dies kann einerseits den Vorteil haben, dass die Säure nicht Kosten-intensiv entsorgt werden muss. Andererseits und zeitgleich ergibt sich der Vorteil, dass im Wesentlichen keine neue Säure für den Ätzprozess zugekauft werden muss, sondern, dass ein- und dieselbe Säure innerhalb eines Wertstoffkreislaufs verbleibt.

In einem Beispiel wird das zweite Diffusat, welches nur noch eine vernachlässigbare Menge des aufzubereitenden Metallsalzes aber eine hohe Säurekonzentration aufweist, in einem Ätzprozess-Sammelbecken gesammelt und dann wieder an den Ätzprozess aus der Leiterplatten- und/oder Substrat-Herstellung bereitgestellt.

Gemäß einem weiteren Ausführungsbeispiel weist das Entfernen ferner auf: Zusammenführen des ersten Dialysats und des zweiten Dialysats, um das konzentrierte aufzubereitende (im Wesentlichen Säure-freie) Metallsalz-haltige Medium bereitzustellen. Dies kann den Vorteil haben, dass eine hohe Metallsalz (aufzubereitendes Metallsalz)-Konzentration erreicht wird und nur ein Schritt zum weiteren Aufbereiten notwendig wird.

Gemäß einem weiteren Ausführungsbeispiel weist das Durchführen der chemischen Reaktion ferner auf: i) Erzeugen von (Reaktions-) Säure in dem Metallsalz-haltigen Medium, ii) (zumindest teilweises) Durchführen der Reaktion in einer dritten Membrandialyse, und iii) Entfernen von einem dritten Teil der Säure aus dem Metallsalz-haltigen Medium mittels der dritten Membrandialyse, um ein drittes Dialysat, welches das Metallsalz aufweist, und ein drittes Diffusat, welches den dritten Teil der Säure aufweist, zu erhalten. Dies kann den Vorteil haben, dass das erwünschte Metallsalz möglichst Säure-frei effizient und Kostengünstig erhalten wird.

In einem Beispiel werden das erste Dialysat und das zweite Dialysat zusammengeführt, um das konzentrierte, im Wesentlichen Säure-freie, aufzubereitende Metallsalz-haltigen Medium bereitzustellen. Für die chemische Reaktion wird zusätzlich eine weitere Säure bereitgestellt, welche z.B. Schwefelsäure (um ein Metallsulfat bereitzustellen) aufweist. Die weitere Säure und das konzentrierte aufzubereitende Metallsalz-haltige Medium werden in einer Mischanlage zusammengeführt, um die chemische Reaktion zu starten. Die chemische Reaktion kann hierbei teilweise in der Mischanlage und/oder teilweise in einer dritten Membrandialyse stattfinden.

In einem Beispiel umfasst die chemische Reaktion das Bereitstellen des Metallsalz-haltigen Mediums mittels Umsalzens aus dem konzentrierten aufzubereitenden Medium (mit dem aufzubereitenden Metallsalz). Bei dem Umsalzen kommt es zu einem erneuten Erzeugen von Säure (insbesondere Salzsäure, oder z.B. Salpetersäure oder Phosphorsäure) in dem nun vorliegenden Metallsalz-haltigen Medium.

In einem exemplarischen Ausführungsbeispiel reagieren Kupferchlorid (als aufzubereitendes Metallsalz) und Schwefelsäure (als weitere Säure) zu Kupfersulfat (erwünschtes Metallsalz) und Salzsäure. Sowohl ein Entfernen dieser (Reaktions-) Säure als auch zumindest ein Teil der chemischen Reaktion werden mittels der dritten Membrandialyse durchgeführt. Dies kann den besonderen Vorteil haben, dass innerhalb eines einzigen Prozessschrittes zwei Einzelschritte gleichzeitig durchgeführt werden.

Gemäß einem weiteren Ausführungsbeispiel weist das Verfahren ferner auf: Bereitstellen des dritten Diffusats als Teilstrom an ein Verfahren zum Aufbereiten eines Metallsalz-haltigen Mediums aus Spülwasser aus der Leiterplatten- und/oder Substrat-Herstellung. Insbesondere wird das dritte Diffusat mittels eines Ionentauschers aufbereitet. Dies kann den Vorteil haben, dass das saure dritte Diffusat, welches nur eine sehr geringe Konzentration an Metallsalz aufweist (zusammen mit weiteren Abtrennströmen anderer Prozesse) einer zentralen Aufbereitung zugeführt wird. Während die Säure innerhalb des Leiterplatten- und/oder Substrat-Herstellungsprozesses wiederverwendet werden kann, wird das Metallsalz aufkonzentriert und kann erneut rückgewonnen werden.

Im Rahmen dieses Dokuments kann unter dem Begriff "Ionentauscher" insbesondere Materialien (bzw. Vorrichtungen) umfassen, mit denen gelöste Ionen durch andere Ionen gleicher Ladung (positiv oder negativ) ersetzt werden können. Ionentauscher können z.B. als Säulen, die mit einem Ionenaustauschmaterial gefüllt sind, oder als Membranen realisiert werden, welche mit einer Lösung durchströmt werden. Die auszutauschenden Ionen werden am Ionenaustauschmaterial gebunden bzw. adsorbiert. In einem Beispiel weist ein Ionentauscher ein selektives Ionenaustauschharz, weiter insbesondere ein doppel-funktionalisiertes Ionenaustauschharz (insbesondere für Fremdmetall-Beseitigung), auf.

In einem Ausführungsbeispiel weist das Trägermaterial des Ionenaustauschharzes des Ionentauscher Polystyrol auf. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Fremdmetall leichter vom Harz desorbiert werden.

In einem Ausführungsbeispiel hat es sich überraschend herausgestellt, dass gerade das Verwenden eines speziellen Ionenaustauschharzes mit zwei funktionellen Gruppen eine (effiziente) Desorption des Metalls (z.B. Kupfer) ermöglicht. Dies ist insbesondere deswegen beachtenswert, weil Ionenaustauschharze (insbesondere einfach-funktionalisierte) teilweise zu einer irreversiblen Adsorption des Metalls neigen. Insbesondere im Fall von Fe³⁺ wurde eine irreversible Adsorption beobachtet.

In einem exemplarischen Beispiel ist der Ionenaustauscher zweistufig aufgebaut. Der nachgeschaltete (zweite) Ionenaustauscher nimmt den Metallrest des vorangeschalteten (zu beladenden) Ionenaustauschers auf. Weist der erste Ionentauscher einen erhöhten Metallrest auf, kann dieser regeneriert und anschließend an die nachgeschaltete (zweite) Stelle geschaltet werden.

Gemäß einem weiteren Ausführungsbeispiel weist der Ionentauscher ein Oxidation-beständiges (insbesondere Wasserstoffperoxid-beständiges) Ionenaustauschharz auf. Dies kann den Vorteil haben, dass auf ein Reduzieren des aufzubereitenden Mediums verzichtet werden kann und/oder, dass der Ionentauscher besonders robust betrieben werden kann.

Gemäß einem weiteren Ausführungsbeispiel weist zumindest ein Zulauf des Diffusats der Membrandialyse (erste, zweite, dritte) ein Lösungsmittel, insbesondere entsalztes Wasser, auf. Dies kann den Vorteil haben, dass ein besonders Kosten-günstiges Abtrennen von Säure ohne weitere zu entsorgende Abfälle durchgeführt werden kann.

Gemäß einem weiteren Ausführungsbeispiel weist die Membrandialyse einen Durchsatz in dem Bereich 0,5 bis 5 L/hm² (insbesondere 1 bis 2 L/hm²) auf. Gemäß einem weiteren Ausführungsbeispiel weist zumindest eine Membran der Membrandialyse eine Wickelmembran oder eine Plattenmembran auf. Dies kann den Vorteil haben, dass etablierte und bewährte Prozesse direkt implementiert werden können.

Gemäß einem weiteren Ausführungsbeispiel wird das Aufbereiten, insbesondere das Entfernen, kontinuierlich betrieben. Dies kann den Vorteil haben, dass ein kontinuierliches Bereitstellen von Metallsalz-haltigem Medium und entsprechendes Rückgewinnen des Metalls ermöglicht ist. Auf diese Weise kann das Entfernen direkt in einen Herstellungsprozess integriert werden.

Gemäß einem weiteren Ausführungsbeispiel weist das Verfahren auf: Entfernen von Wasserstoffperoxid (H₂O₂). Wasserstoffperoxid ist ein starkes Oxidationsmittel, welches die Membranen der Membrandialyse und das Ionenaustauschharz eines Ionentauschers beschädigen bzw. zerstören kann. Entsprechend vorteilhaft kann das Entfernen von Wasserstoffperoxid sein. Zudem werden keine Kosten-intensiven Schutzmaterialien gegen Wasserstoffperoxid benötigt.

Gemäß einem weiteren Ausführungsbeispiel weist das Verfahren weiter auf: Aufkonzentrieren des Metallsalzes in dem Metallsalz-haltigen Medium, insbesondere mittels eines Verdunsters (insbesondere eines Verdunsterturms). Dies kann den Vorteil haben, dass ein hoch-konzentriertes Medium dem Rückgewinnen zugeführt werden kann, wodurch sich der Prozess noch effizienter gestalten lässt.

Gemäß einem weiteren Ausführungsbeispiel weist das Verfahren weiter auf: Rückgewinnen von elementarem Metall aus dem Metallsalz-haltigen Medium in einer Reaktionszelle (insbesondere mittels Elektrolyse). Das elementare Metall (z.B. Kupfer) des Metallsalz-haltigen Mediums soll in der Reaktionszelle in (hoch) reiner Form rückgewonnen werden, um einem/dem Prozess zum Herstellen von Leiterplatten und/oder Substraten erneut zugeführt zu werden. Insbesondere wird das erhaltene elementare Metall in einen/den Galvanisierungsprozess rückgeführt. In einem weiteren Beispiel kann das rückgewonnen Metall auch in den Ätzprozess rückgeführt werden.

Gemäß einem weiteren Ausführungsbeispiel weist die Berechnungsvorrichtung einen selbstlernenden Algorithmus (insbesondere mittels neuronaler Netzwerke) auf zum Vergleichen und/oder zum Bestimmen. Dies kann den Vorteil bereitstellen, dass die Prozesskontrollvorrichtung (zumindest teilweise) selbstständig arbeiten und sich basierend hierauf weiterentwickeln kann. Ein selbstlernender Algorithmus (maschinelles Lernen) kann ein künstliches System sein, welches aus Beispielen (bzw. Anwendungen) lernt und diese (nach oder während einer Lernphase) verallgemeinert. Ein solcher Algorithmus kann z.B. mittels neuronaler Netzwerke realisiert werden.

Gemäß einem weiteren Ausführungsbeispiel i) ist der selbstlernende Algorithmus eingerichtet, die bestimmte Steueroperation automatisch durchzuführen, und/oder ii) der selbstlernende Algorithmus ist eingerichtet die bestimmte Steueroperation einem Benutzer zum Überprüfen bereitzustellen. Dadurch kann sich der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist i) der selbstlernende Algorithmus eingerichtet basierend auf dem Vergleichen einen neuen vorbestimmten Prozessparameter zu bestimmen und automatisch der Datenmodell-Einheit zuzuführen und/oder ii) der selbstlernende Algorithmus ist eingerichtet basierend auf dem Vergleichen einen neuen vorbestimmten Prozessparameter zu bestimmen und dem Benutzer zum Überprüfen bereitzustellen. Dadurch kann sich ebenfalls der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist der selbstlernende Algorithmus eingerichtet, das Ergebnis des Überprüfens durch den Benutzer als Lerngrundlage zu verwenden. Dies kann den Vorteil bereitstellen, dass sich der selbstlernende Algorithmus während dem Betreiben des Verfahrens ständig in einer gewünschten Richtung weiterentwickelt und über die Zeit immer mehr Aufgaben direkt umsetzen kann.
Im Folgenden werden exemplarische Ausführungsbeispiele der vorliegenden Erfindung mit Verweis auf die folgenden Figuren detailliert beschrieben.
Die **Figuren 1 bis 3** zeigen jeweils eine Übersicht der Teilströme beim Herstellen von Leiterplatten und/oder Substraten gemäß Ausführungsbeispielen der Erfindung.
Die **Figuren 4 bis 7** zeigen einen ersten Aufbereitungsprozess eines Metallsalz-haltigen Mediums aus einem Ätzprozess aus der Leiterplatten- und/oder Substrat-Herstellung gemäß Ausführungsbeispielen der Erfindung.
Die **Figur 8** zeigt eine Übersicht der Aufbereitungsprozesse und des Rückgewinnens bei der Leiterplatten- und/oder Substrat-Herstellung gemäß einem Ausführungsbeispiel der Erfindung.
Die **Figur 9** zeigt eine Prozesskontrollvorrichtung zum Regulieren von zumindest einem Teil des oben beschriebenen Verfahrens (bzw. der Industrieanlage) gemäß einem Ausführungsbeispiel der Erfindung.

Gleiche oder ähnliche Komponenten in unterschiedlichen Figuren sind mit gleichen Bezugsziffern versehen.

Im Folgenden wird ein Prozess beschrieben zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Dieser Prozess ermöglicht es, dass anfallende Rückstände der Leiterplatten- und/oder Substrat-Herstellung in Teilströmen derart in einem Wertstoffkreislauf transportiert und rückgeführt werden können, dass im Betriebszustand des Verfahrens zum Herstellen von Leiterplatten und/oder Substraten als Abfall (im Wesentlichen) letztlich nur ein Medium in Einleitqualität (insbesondere in Kläranlagen oder Gewässer) anfällt.

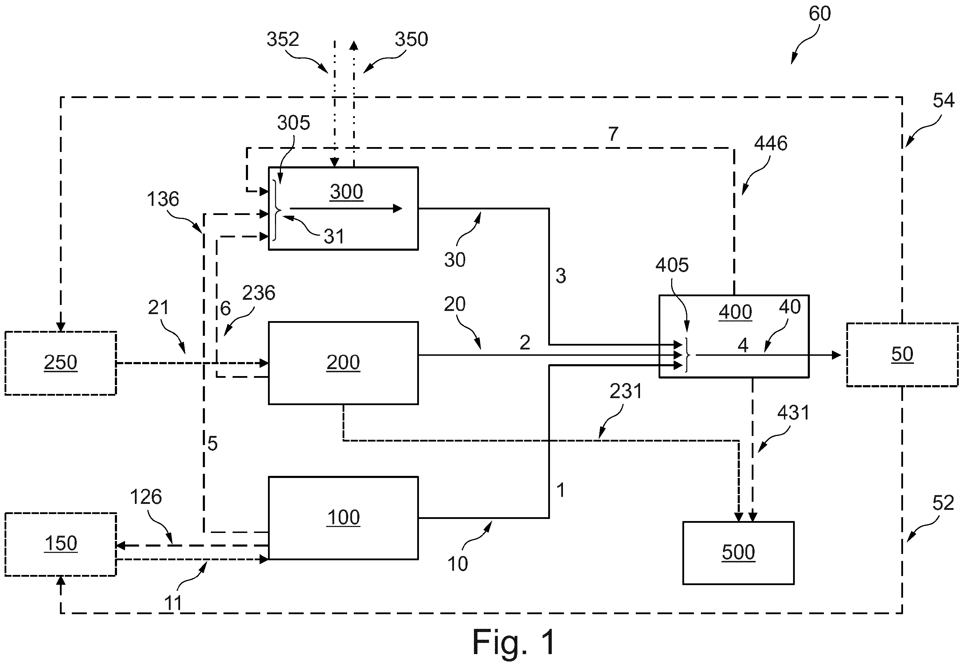

**Figur 1** zeigt eine Übersicht von Strömen 1 bis 7 beim Herstellen von Leiterplatten und/oder Substraten, z.B. in einer Industrieanlage 60, gemäß einem Ausführungsbeispiel der Erfindung. Das Verfahren zum Herstellen von Leiterplatten und/oder Substraten wird derart betrieben, dass die anfallenden Prozess-Rückstände 11, 21, 31 in drei hauptsächlichen Teilströmen 1, 2, 3 (und insbesondere zumindest teilweise als Gesamtstrom 4) und drei hauptsächlichen Abtrennströmen 5, 6, 7 (welche insbesondere Säure-Rückstände aufweisen) derart in einem Wertstoffkreislauf geleitet und rückgeführt (bzw. recycelt) werden, dass in dem (gezeigten) Betriebszustand des Herstellungsverfahrens als Abfall (im Wesentlichen) nur ein Medium 350 in Einleitqualität anfällt. In anderen Worten weist das Medium 350 in Einleitqualität (im Wesentlichen) keine Hauptkomponenten (insbesondere kein Schwermetall) der Leiterplatten/Substrat-Herstellung mehr auf, sondern besteht lediglich aus Wasser, Salzen, und organischem Material. Dem Herstellungsverfahren müssen im (gezeigten) Betriebszustand (im Wesentlichen) also nur Wasser 352 und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Prinzipiell können in dem beschriebenen Wertstoffkreislauf 95% oder mehr, insbesondere 98% oder mehr, der Schwermetall-Rückstände (z.B. Kupfer Rückstände) rückgeführt werden. In einem exemplarischen Beispiel des Wertstoffkreislauf werden mindestens 80% (insbesondere mindestens 85%, weiter insbesondere mindestens 90%) der abgetrennten Salzsäure rückgeführt, und mindestens 70% (insbesondere mindestens 75%, weiter insbesondere mindestens 80%) der benötigten Schwefelsäure Verfahrens-intern produziert. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Die anfallenden Rückstände 11, 21, 31 bzw. Abfallkonzentrate können als aufzubereitende Metallsalz-haltige Medien bezeichnet werden und weisen in einem exemplarischen Ausführungsbeispiel u.a. auf: Kupfer, Kupfersulfat, Kupferchlorid, Eisen, Nickel, Gold, Salzsäure, Schwefelsäure. Die aufzubereitenden Metallsalz-haltigen Medien 11, 21, und 31 werden jeweils in einem entsprechenden Aufbereitungsprozess 100, 200, 300 aufbereitet und dann als Teilströme 1, 2, 3, welche jeweils aufbereitetes Metallsalz-haltiges Medium 10, 20, 30 aufweisen, einem Rückgewinnungsprozess 400 zugeführt. Nach der Aufbereitung schließlich wird rückgewonnenes, elementares Metall 50 wieder in den Herstellungsprozess eingespeist (Pfeile 52 und 54). Im Folgenden wird ein prinzipieller Überblick über die Teilströme 1 bis 7 innerhalb des Wertstoffkreislaufs gegeben. Weiter unten folgen dann detaillierte Beschreibungen der einzelnen Prozesse.

Der erste Teilstrom 1 weist ein erstes aufbereitetes Metallsalz-haltiges Medium 10 aus einem Ätzprozess 150 der Leiterplatten- und/oder Substrat-Herstellung auf, welches in einem ersten Aufbereitungsprozess 100 aufbereitet wird. Das erste aufbereitete Metallsalz-haltige Medium 10 (welches im Wesentlichen kein aufzubereitendes Metallsalz aufweist) wird aus dem aufzubereitenden Medium 11 aus dem Ätzprozess 150 erhalten. Das aufzubereitende Medium 11 weist ein aufzubereitendes Metallsalz (z.B. Kupferchlorid) und eine Säure auf. Das Aufbereiten 100 umfasst ein mehrstufiges Entfernen 110, 120 der Säure mittels Membrandialyse und Durchführen einer chemischen Reaktion 140. Bei der Membrandialyse fällt ein erstes Säure-haltiges Diffusat 136 an. Ein weiteres Säure-haltiges Diffusat 126 kann direkt an den Ätzprozess 150 bereitgestellt werden.

Der zweite Teilstrom 2 weist ein zweites aufbereitetes Metallsalz-haltiges Medium 20 aus einem Galvanisierungsprozess 250 der Leiterplatten- und/oder Substrat-Herstellung auf. Das zweite aufbereitete Metallsalz-haltige Medium 20 (welches im Wesentlichen kein Eisen aufweist) wird aus einem Eisen- und Metallsalz-haltigen Medium 21 aus dem Galvanisierungsprozess 250 erhalten. Das Aufbereiten 200 umfasst ein Separieren des Eisens aus dem Eisen- und Metallsalz-haltigen Medium 21 mittels eines Ionentauschers 220. Bei einem Regenerieren 222 des Ionentauschers 220 fällt ein zweites Säure-haltiges Diffusat 236 an.

Der dritte Teilstrom 3 weist ein drittes aufbereitetes Metallsalz-haltiges Medium 30 aus Spülwasser 32 bzw. einer Spülwasser Mischung 31 der Leiterplatten- und/oder Substrat-Herstellung auf. Das dritte aufbereitete Metallsalz-haltige Medium 30 wird in einem dritten Aufbereitungsprozess 300 unter Verwenden eines Ionentauschers 320 erhalten, wobei das Metallsalz in dem aufbereiteten Metallsalz-haltigen Medium 30 im Vergleich zu dem Spülwasser 32 aufkonzentriert ist.

Die Teilströme 1, 2, 3 können (zumindest teilweise) vereint werden (siehe Schritt 405) zu einem Gesamtstrom 4 oder auch einzeln aufbereitet werden. Das Aufbereiten 400 umfasst ein Rückgewinnen 400 des elementaren Metalls 50 (z.B. elementares Kupfer) aus dem Metallsalz-haltigen Medium 40 in einer (Elektrolyse-) Reaktionszelle 450. Das (kontinuierliche) Einstellen der Zusammensetzung des Metallsalz-haltigen Mediums 40 als Elektrolyten umfasst ein Abtrennen 440 von Säure mittels Membrandialyse, wobei ein drittes Säure-haltiges Diffusat 446 anfällt. Alternativ kann das Diffusat 446 auch zur Regeneration eines Ionentauschers 320 zur Aufbereitung der Spülwässer herangezogen werden. Hierbei bleibt das Metall (insbesondere Kupfer) ebenfalls im Wertstoffkreislauf und kann daher nahezu vollständig aus dem Metallsalz-haltigen Medium entfernt werden. Das hat den Vorteil, dass ein weiterer Aufbereitungsschritt mittels Membrandialyse eingespart werden kann. Das erhaltene hochreine Metall 50 wiederum ist geeignet erneut in den Ätzprozess 150 rückgeführt (siehe Pfeil 52) zu werden und/oder in den Galvanisierungsprozess 250 rückgeführt (siehe Pfeil 54) zu werden.

Ein erster Abtrennstrom 5 stammt aus dem ersten Aufbereitungsprozess 100 und weist das erste Säure-haltige Diffusat 136 auf. Ein zweiter Abtrennstrom 6 stammt aus dem zweiten Aufbereitungsprozess 200 und weist das zweite Säure-haltige Diffusat 236 auf. Ein dritter Abtrennstrom 7 stammt aus dem Aufbereitungsprozess 410 des Gesamtstroms 4 und weist das dritte Säure-haltige Diffusat 446 auf. Die Abtrennströme 5, 6, 7 weisen jeweils das Metallsalz (z.B. Kupfersulfat) in geringer Konzentration auf, bzw. in geringerer Konzentration als die Konzentration des Metallsalzes in dem dritten Teilstrom 3. Die Abtrennströme 5, 6, 7 werden (zumindest teilweise) zusammengeführt (siehe Schritt 305) zu einem aufzubereitenden Medium 31 bzw. einer Mischung an Spülwässern (Gesamtabtrennstrom). Auch weitere Spülwässer 32 des Herstellungsverfahrens können hier einfließen. Das aufzubereitende Medium 31 wird, wie oben beschrieben, mittels des dritten Aufbereitungsprozesses 300 aufbereitet, um die Konzentration für das Rückgewinnen 400 deutlich zu erhöhen.

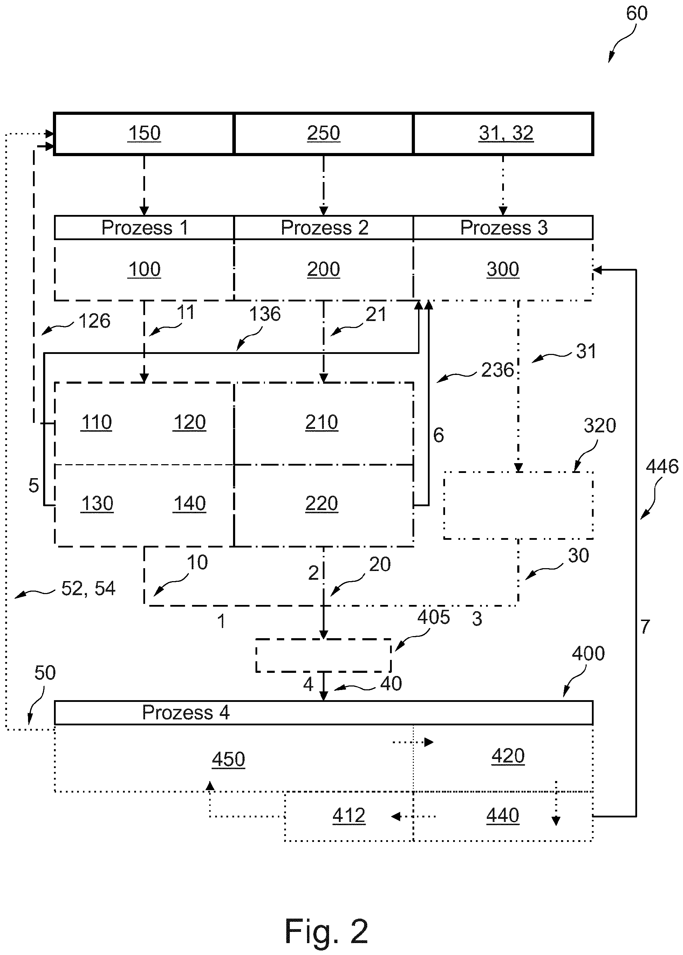

**Figur 2** zeigt eine Übersicht der Teilströme beim Herstellen von Leiterplatten und/oder Substraten, z.B. in einer Industrieanlage 60, gemäß einem weiteren Ausführungsbeispiel der Erfindung. Der Wertstoffkreislauf entspricht dem für Figur 1 oben beschriebenen in anderer Darstellungsweise. Es ist ferner gezeigt, dass das Rückgewinnen 400 ein (kontinuierliches) Einstellen der Zusammensetzung des Elektrolyten (bzw. des Metallsalz-haltigen Mediums) 40 aufweist. So wird der Elektrolyt aus der Reaktionszelle 450 (kontinuierlich) behandelt mittels eines organischen Filters 412, eines Separierens von Fremdmetall 420, und eines Separierens von Säure 440 (bei zu hoher Säurekonzentration).

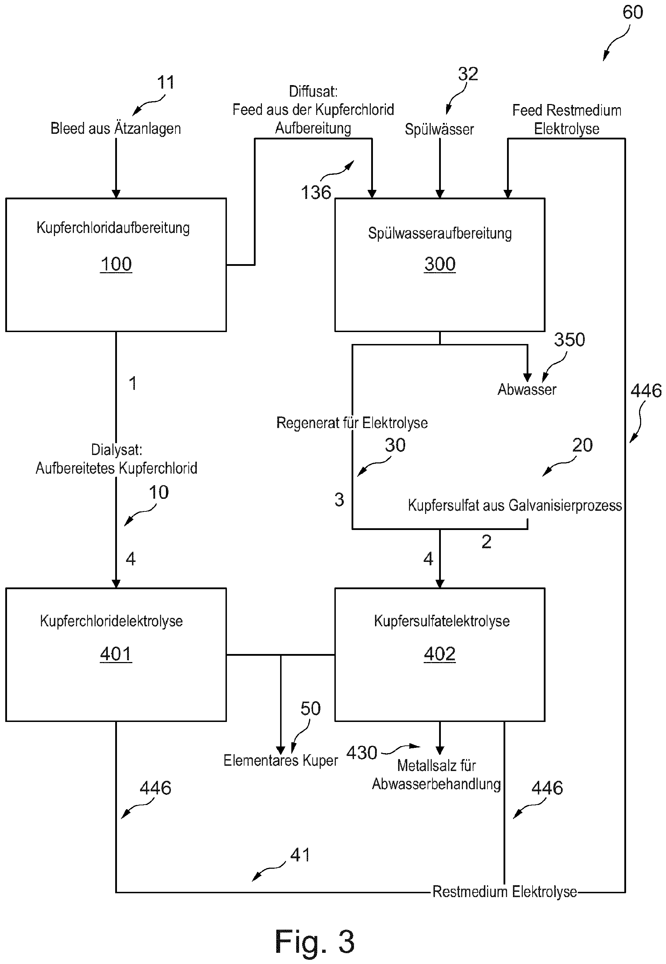

**Figur 3** zeigt ein exemplarisches Ausführungsbeispiel des für die Figuren 1 und 2 bereits beschriebenen Herstellens von gedruckten Leiterplatten und/oder Substraten. In diesem spezifischen Ausführungsbeispiel weist das aufzubereitende Metallsalz Kupferchlorid auf und das Metallsalz weist Kupfersulfat auf. Der Unterschied zu dem für die Figuren 1 und 2 beschriebenen Prozess besteht darin, dass der erste Teilstrom 1 einem ersten Rückgewinnungsprozess 401 (der Begriff "Kupferchloridelektrolyse" bezieht sich hierbei auf das Ausgangsmaterial, es findet eigentlich eine Kupfersulfatelektrolyse statt) zugeführt wird und ein Gesamtstrom 4, welcher aus dem zweiten Teilstrom 2 und dem dritten Teilstrom 3 besteht, einem zweiten Rückgewinnungsprozess 402 zugeführt wird.

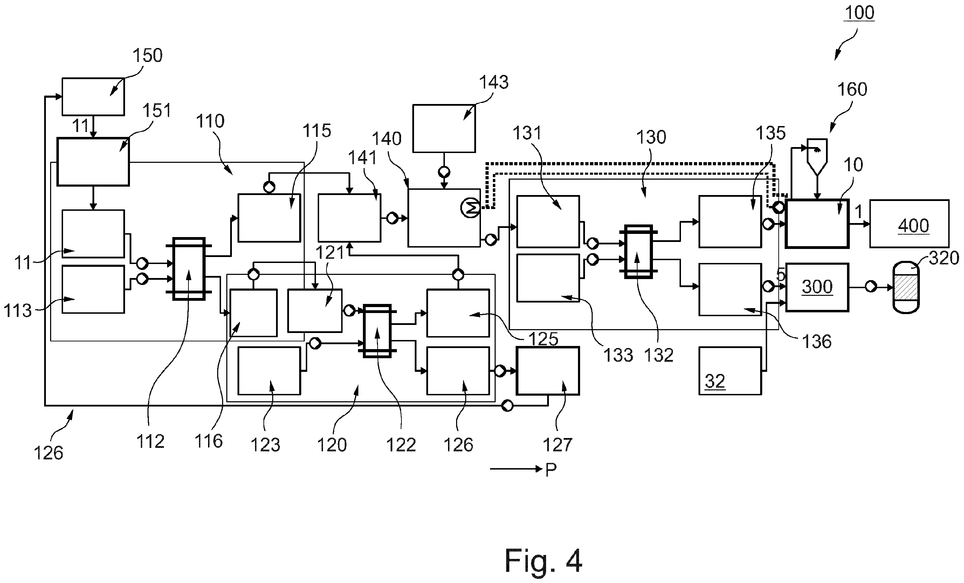

**Figur 4** zeigt den ersten Aufbereitungsprozess 100 zum Bereitstellen des ersten Metallsalz-haltigen Mediums 10 aus einem Ätzprozess 150 aus der Leiterplatten- und/oder Substrat-Herstellung gemäß Ausführungsbeispielen der Erfindung. Der erste Aufbereitungsprozess 100 umfasst ein Verfahren zum Aufbereiten eines aufzubereitenden Mediums 11 aus dem Ätzprozess 150, wobei das aufzubereitende Medium 11 ein aufzubereitendes Metallsalz und eine Säure 15 aufweist, um das erste Metallsalz-haltige Medium 10 bereitzustellen. Die Prozessrichtung ist mit dem Pfeil P angezeigt.

In den folgenden Ausführungsbeispielen wird meist Kupfer als exemplarisches Beispiel verwendet. Gleiches gilt aber auch für weitere Metalle wie z.B.: Nickel, Cobalt, Rhodium, Zinn, Cadmium, Magnesium, Natrium. Diese können mit Säuren (z.B. Salzsäure, Schwefelsäure, Salpetersäure, Phosphorsäure) Metallsalze bilden.

Gemäß einem exemplarischen Ausführungsbeispiel fällt aus dem Ätzprozess 150 als aufzubereitendes Medium 11 Kupfer in Form von Kupferchlorid (als aufzubereitendes Metallsalz) und Salzsäure als Säure 15 an. Der hohe Anteil an Chlorid-Ionen begünstigt während eines Rückgewinnes, z.B. Elektrolyse, die unkontrollierbare Bildung von Chlorgas. Zusätzlich können sich Chlorid-Ionen an der Elektrode mit abscheiden, welche die Reinheit des abgeschiedenen Kupfers negativ beeinflussen. Daher wird in dem ersten Aufbereitungsprozess 100 das Kupferchlorid in Kupfersulfat umgewandelt, während die freie Säure 15 abgetrennt wird.

Der erste Aufbereitungsprozess 100 weist nun prinzipiell zwei Verfahrensschritte auf: i) mehrstufiges Entfernen 110, 120 der Säure 15 aus dem Säure-haltigen aufzubereitenden Medium 11 mittels Membrandialyse, um ein konzentriertes, im wesentlichen Säure-freies, aufzubereitendes Medium 141 bereitzustellen, und nachfolgend ii) Durchführen einer chemischen Reaktion 140 zum Erzeugen des Metallsalz-haltigen Mediums 10 aus dem konzentrierten, im wesentlichen Säurefreien, aufzubereitenden Medium 141.

Es hat sich hierbei herausgestellt, dass die chemische Reaktion 140 (insbesondere Kupferchlorid zu Kupfersulfat) stark exotherm ist, so dass dadurch entstehende Abwärme zusätzlich als Energiequelle genutzt werden kann. In einem exemplarischen Beispiel können auf diese Weise 800 kW pro Tag durch die chemische (exotherme) Reaktion bereitgestellt werden. Diese Energie kann wiederum direkt eingesetzt (abgeleitet bzw. umgeleitet) werden, um ein flüssiges Medium (z.B. in einem Versorgungsbecken 310, 410 oder einem Elektrolysebecken einer Reaktionszelle 450) innerhalb ein und desselben Leiterplatten- und/oder Substrat-Herstellungsprozesses zu erwärmen/heizen. Überraschenderweise hat sich also gezeigt, dass dem Wertstoffkreislauf weniger Energie hinzugeführt werden muss, weil eine exotherme, Prozess-interne Reaktion als effiziente Energiequelle verwendet werden kann.

Das aufzubereitende Metallsalz-haltige Medium 11 wird in einem Überlaufbecken 151 des Ätzprozesses 150 gesammelt und als Dialysat 11 der ersten Membrandialyse 110 zugeführt. Weiterhin wird der Membrandialyse 110 entsalztes Wasser über einen ersten Diffusat Zulauf 113 zugeführt.

Die Membran 112 kann hierbei z.B. eine Wickelmembran oder eine Plattenmembran aufweisen. Die Membran 112 ist semipermeabel und lässt Anionen (z.B. Chlorid) passieren (Anionen-Membran), während Kationen (z.B. Cu²⁺) nicht passieren können. Die Membrandialyse 110 weist einen Durchsatz in dem Bereich 0,5 bis 5 L/hm² (insbesondere 1 bis 2 L/hm²) auf. Es kann für die im folgenden beschriebenen Membrandialysen jeweils dieselbe Membran eingesetzt werden oder (bevorzugt) werden unterschiedliche Membranen verwendet (z.B. je nachdem aus welchem (Ätz-) Prozess die jeweilige Metallsalz-haltige Lösung stammt). Eine Anionen-Membran kann z.B. mit Brom (Br⁻) funktionalisiert sein, wobei das Trägermaterial beispielsweise PET oder PVC sein kann. In bestimmten Fällen kann die Metallsalz-haltige Lösung Wasserstoffperoxid (H₂O₂) beinhalten. In diesem Fall kann bevorzugt eine oxidationsbeständige Membran genutzt werden, welche z.B. auf PEEK (Polyetheretherketon-Trägermaterial) basiert.

Es wird ein erster Teil der Säure 15a aus dem aufzubereitenden Medium 11 mittels der ersten Membrandialyse 110 entfernt, um ein erstes Dialysat 115 mit einer ersten Konzentration des aufzubereitenden Metallsalzes und ein erstes Diffusat 116, welches den ersten Teil der Säure 15a aufweist, zu erhalten.

Das erste Diffusat 116 weist ferner eine zweite Konzentration (welche geringer ist als die erste Konzentration) des aufzubereitenden Metallsalzes auf. Dies liegt daran, dass doch einige Kationen die Membran 112 passieren, insbesondere wenn die Kationen mit den Anionen einen Komplex bzw. ein Aggregat (z.B. einen Kupfer-Chlor Komplex) bilden. Ohne an eine bestimmte Theorie gebunden sein zu wollen, wird derzeit davon ausgegangen, dass eine solche Aggregat-Bildung stattfinden kann, wenn die Konzentration der Kationen in einer Lösung erhöht ist.

Nachfolgend wird das erste Diffusat 116 einer zweiter Membrandialyse 120 unterzogen. Das erste Diffusat 116 wird hierbei der zweiten Membrandialyse 120 als Dialysat Zulauf 121 zugeführt. Als zweiter Diffusat Zulauf 123 wird entsalztes Wasser verwendet. Ein zweiter Teil der Säure 15b wird aus dem ersten Diffusat 116 entfernt, um ein zweites Dialysat 125 mit einer dritten Konzentration (welche kleiner ist als die zweite Konzentration) des aufzubereitenden Metallsalzes und ein zweites Diffusat 126, welches den zweiten Teil der Säure 15b aufweist, zu erhalten. Das erste Diffusat 116 weist ferner eine zweite Konzentration des aufzubereitenden Metallsalzes auf. Das zweite Diffusat 126 weist eine vierte Konzentration des aufzubereitenden Metallsalzes auf, welche kleiner ist als die dritte Konzentration. Die Konzentration an Kationen des aufzubereitenden Metallsalzes in dem ersten Diffusat 116 ist deutlich geringer als die Kationen-Konzentration in dem Dialysat-Zulauf 11. Daher wird davon ausgegangen, dass sich nun im Wesentlichen keine Aggregate mehr bilden, und nur noch eine vernachlässigbare Menge an Kationen durch die Membran 112, 122 diffundiert. Aus diesem Grund werden vorzugsweise genau zwei Membrandialyse-Stufen 110, 120 durchgeführt. Dadurch kann in vorteilhafter Weise eine hohe Konzentration des Metallsalzes erreicht werden während zugleich die Menge an eingesetzter Flüssigkeit nicht zu hoch wird.

Das zweite Diffusat 126, welches nur noch eine vernachlässigbare Menge des aufzubereitenden Metallsalzes aber eine hohe Säurekonzentration aufweist, wird in einem Ätzprozess-Sammelbecken 127 gesammelt und dann wieder an den Ätzprozess 150 aus der Leiterplatten- und/oder Substrat-Herstellung bereitgestellt. Insbesondere wird das zweite Diffusat 126 zunächst aufbereitet.

Das erste Dialysat 115 und das zweite Dialysat 126 werden zusammengeführt, um das konzentrierte, im Wesentlichen Säure-freie, aufzubereitende Metallsalz-haltigen Medium 141 bereitzustellen. Zusätzlich wird eine weitere Säure 143 bereitgestellt, welche z.B. Schwefelsäure aufweist. Die weitere Säure 143 und das konzentrierte aufzubereitende Metallsalz-haltige Medium 141 werden in einer Mischanlage 140 (z.B. Kustan Mischanlage) zusammengeführt, um die chemische Reaktion 140 zu starten. Die chemische Reaktion 140 findet teilweise in der Mischanlage 140 und/oder teilweise in einer dritten Membrandialyse 130 statt. Die Reaktion 140 umfasst das Erzeugen eines Metallsalz-haltigen Mediums 10 mittels Umsalzens aus dem konzentrierten aufzubereitenden Medium 141. Bei dem Umsalzen kommt es zur Erzeugung von Säure 15 (insbesondere Salzsäure) in dem nun vorliegenden Metallsalz-haltigen Medium 10. In einem exemplarischen Ausführungsbeispiel reagieren Kupferchlorid (als aufzubereitendes Metallsalz) und Schwefelsäure (als weitere Säure) zu Kupfersulfat (Metallsalz) und Salzsäure. Sowohl ein Entfernen dieser Säure als auch zumindest ein Teil der chemischen Reaktion 140 werden mittels der dritten Membrandialyse 130 durchgeführt.

Die Mischung aus der weiteren Säure 143 und dem konzentrierten aufzubereitenden Medium 141 werden als Dialysat Zulauf 131 der dritten Membrandialyse 130 zugeführt. Als dritter Diffusat Zulauf 133 wird entsalztes Wasser verwendet. Es wird ein drittes Dialysat 135 erhalten, welches das Metallsalz aufweist, und ein drittes Diffusat 136, welches einen dritten Teil der Säure 15c aufweist.

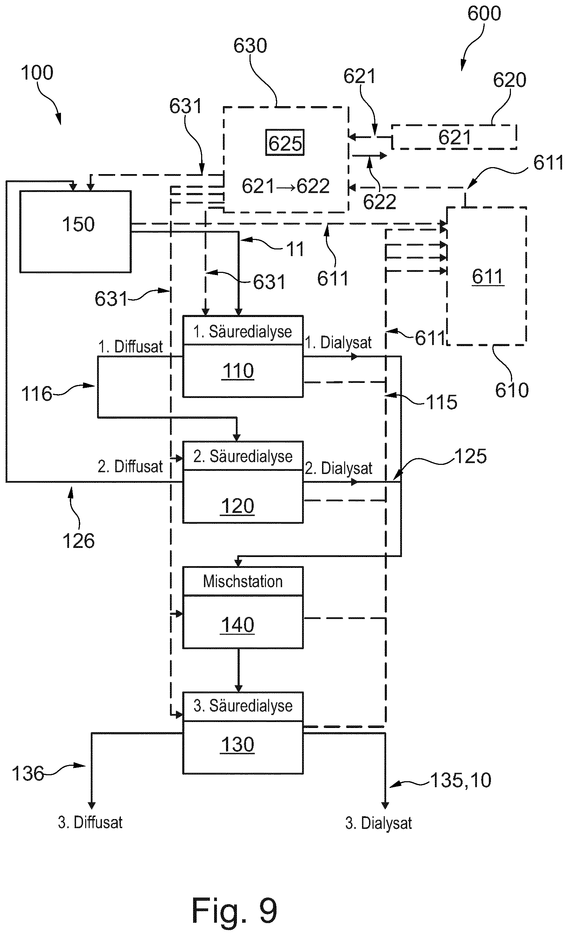

Das dritte Diffusat 136 enthält nun die Säure 15 und die weitere Säure (z.B. Salzsäure und Schwefelsäure) und eine geringe Konzentration des Metallsalzes. Dieses dritte Diffusat 136 wird im Zuge des ersten Abtrennstroms 5 an ein Verfahren 300 bereitgestellt zum Aufbereiten eines Metallsalz-haltigen Mediums aus Spülwasser aus der Leiterplatten- und/oder Substrat-Herstellung. In diesem Verfahren 300 wird das dritte Diffusat 136 (vorzugsweise mit weiterem Spülwasser 32) mittels eines Ionentauschers 320 aufbereitet (siehe Figuren 9 und 10).

Das dritte Dialysat 135 (optional mittels eines Verdunsters 160 aufkonzentriert) stellt das Metallsalz-haltige Medium 10 dar. Dieses wird über den ersten Teilstrom 1 an ein Verfahren zum Rückgewinnen 400 des elementaren Metalls aus dem Metallsalz-haltigen Medium 10 bereitgestellt (siehe Figuren 11 bis 14).

In einem bevorzugten Beispiel weist das Verfahren 100 auf: Vorgeben eines Maximalwerts für das Volumen zumindest eines Diffusats-Zulaufs 113, 123, 133 der Membrandialyse 110, 120, 130 und Vorgeben eines Minimalwerts für die Konzentration an aufzubereitendem Metallsalz. Die Prozessparameter (z.B. Durchflussgeschwindigkeit, Durchflussvolumen etc.) werden derart gesteuert (bzw. geregelt), dass der vorgegebene Maximalwert nicht überschritten wird und der vorgegebene Minimalwert nicht unterschritten wird. Dies führt in besonders vorteilhafter Weise dazu, dass keine unnötig großen Mengen an flüssigem Medium (bzw. Wasser und Säure) anfallen, sondern immer mit höchstmöglichen Konzentrationen an Metallsalz gearbeitet wird. Daher kann es sich anbieten, lediglich genau zwei Membrandialyse-Stufen 110, 120 durchzuführen, wodurch eine optimale Ausbeute bereitgestellt wird ohne, dass große Mengen an flüssigem Medium bei drei oder mehr Dialysen anfallen. In einem weiteren bevorzugten Ausführungsbeispiel wird das Verfahren 100, insbesondere das Entfernen 110, 120, 130, kontinuierlich betrieben.

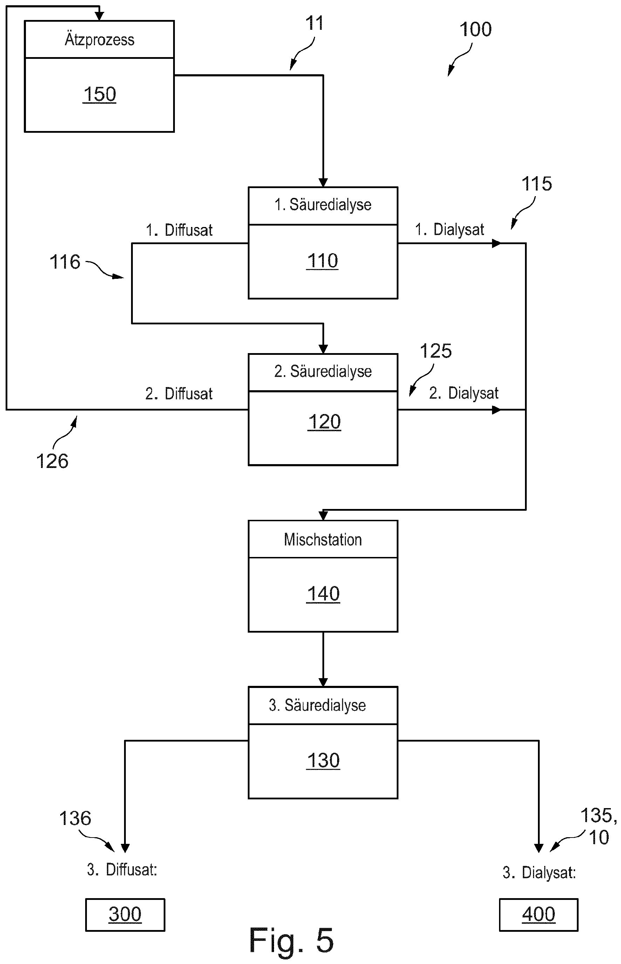

**Figur 5** zeigt den ersten Aufbereitungsprozess 100 des Metallsalz-haltigen Mediums aus einem Ätzprozess 150 aus der Leiterplatten- und/oder Substrat-Herstellung, welcher in Figur 4 im Detail beschrieben wurde, nochmals aus Gründen der Übersichtlichkeit als Flussdiagram.

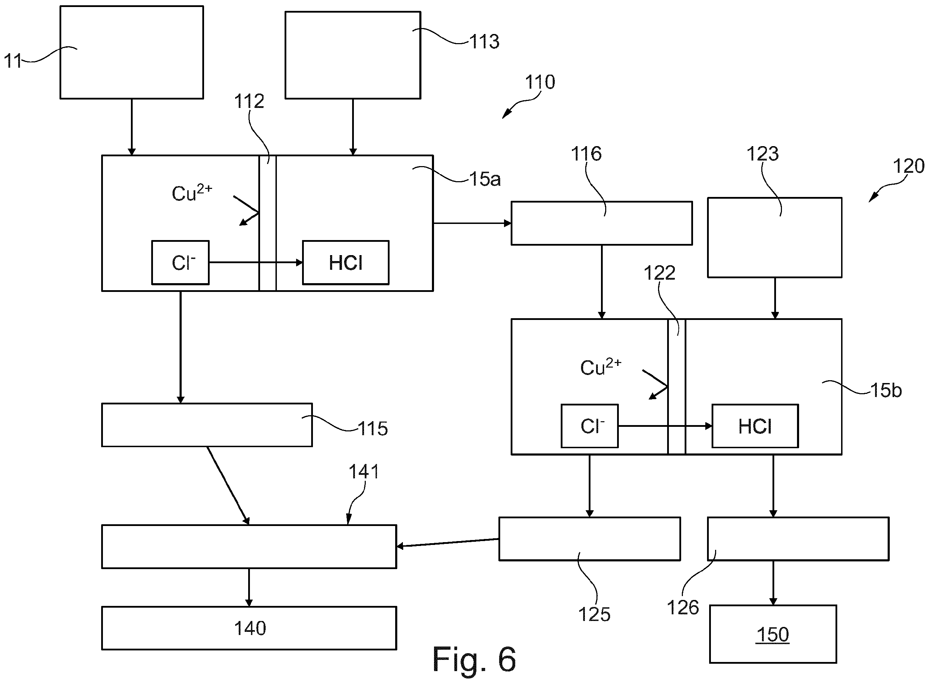

**Figur 6** zeigt ein exemplarisches Ausführungsbeispiel der ersten Membrandialyse 110 und der zweiten Membrandialyse 120, wobei in diesem konkreten Beispiel das aufzubereitende Medium 11 Kupferchlorid (aufzubereitendes Metall) und Salzsäure (Säure 15) aufweist. Bei der Membrandialyse bzw. Säuredialyse sind zwei Zuläufe 11, 113 notwendig, welche örtlich voneinander mittels einer semipermeablen Membran 112 getrennt sind. Die Membran 112 ist mit einer dauerhaft positiven Ladung konditioniert und sowohl für negative Ionen als auch für H⁺ durchlässig, nicht jedoch für positive Kupfer Ionen (Cu²⁺). Mit diesem Aufbau ergeben sich auch zwei örtlich getrennte Abläufe (erstes Diffusat 116 und erstes Dialysat 115), die ebenfalls voneinander durch dieselbe Membran 112 getrennt sind. Der Zulauf 113 auf der Diffusat-Seite besteht aus voll entsalztem Wasser (VE-Wasser), während der Zulauf auf der Dialysat-Seite das aufzubereitende Medium 11 aus dem Ätzprozess 150 darstellt. Die unterschiedliche Stoffkonzentration (insbesondere Säurekonzentration) zwischen den beiden Zuläufen 11, 113 ist die treibende Kraft der die Dialyse bewirkenden Diffusion. Durch den kontinuierlichen Betrieb bleibt eine bestimmte Konzentrationsdifferenz entlang der Membran 112 erhalten und die Trennung kann ebenfalls kontinuierlich erfolgen. Die Salzsäure 15 diffundiert auf Grund des Konzentrationsunterschieds auf die Diffusat-Seite des Wassers 113, während sich auf der Seite des Dialysats Kupfer anreichert. Geringe Konzentrationen an Kupfer gelangen auch in das erste Diffusat 116, während der Hauptteil des Kupfers im ersten Dialysat 115 verbleibt. Dennoch kann die Kupfer-Konzentration im ersten Diffusat 116 in bestimmten Fällen um die 30% der Konzentration des Kupfers in dem aufzubereitenden Medium 11 betragen. Das erste Diffusat 116 wird daher mittels der zweiten Membrandialyse 120 aufbereitet, um möglichst viel weiteres Kupfer abzutrennen. Das zweite Diffusat 126 der zweiten Membrandialyse 120 wird in den Ätzprozess 150 zurückgeführt, während das zweite Dialysat 125 der zweiten Membrandialyse 120 mit dem ersten Dialysat 115 aus der ersten Membrandialyse 110 gemeinsam als konzentriertes (Säure-freies) aufzubereitendes Medium 141 weiter aufbereitet wird.

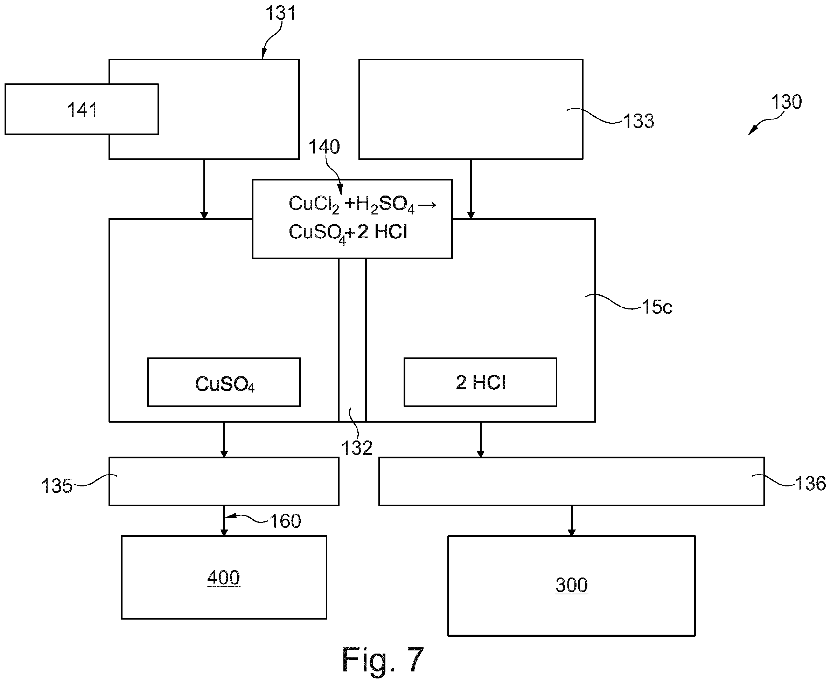

**Figur 7** zeigt ein exemplarisches Ausführungsbeispiel der chemischen Reaktion 140 und der dritten Membrandialyse 130, wobei in diesem konkreten Beispiel das konzentrierte und im Wesentlichen Säure-freie aufzubereitende Medium 141 (das im Wesentlichen Kupferchlorid aufweist) nach dem Beispiel von Figur 6 (siehe oben) verwendet wird. Während das zweite Diffusat 126 zurück in den Ätzprozess 150 geführt wird, wird das konzentrierte aufzubereitende Medium 141 in einem weiteren Schritt (zumindest teilweise) mit Hilfe der dritten Membrandialyse 130 zu Kupfersulfat umgewandelt. Dazu wird das konzentrierte aufzubereitende Medium 141 in Schwefelsäure 143 aufgegeben. Dabei wandelt sich teilweise Kupferchlorid in Kupfersulfat um. Das Gleichgewicht dieser Reaktion liegt jedoch auf der Seite des Edukts, welches die vollständige Umwandlung zu Kupfersulfat verhindert und die Bildung des Kupferchlorids bevorzugt. Mittels der dritten Membrandialyse 130 ist es jedoch möglich die gebildete Salzsäure in-situ abzutrennen und so das Reaktionsgleichgewicht auf die Seite des Kupfersulfats zu treiben. Folglich werden während der Dialyse 130 kontinuierlich Kupfersulfat und Salzsäure gebildet, wobei letztere kontinuierlich abgetrennt wird. Als (dritter) Diffusat Zulauf 133 wird VE-Wasser verwendet. Im dritten Dialysat 135 befindet sich das umgewandelte Kupfersulfat (so dass das Metallsalz-haltige Medium 10 vorliegt), während sich die Säuren (Salzsäure und Schwefelsäure) auf der Seite des dritten Diffusats 136 ansammeln. Geringe Konzentrationen an Kupfer gelangen auch bei diesem Schritt in das dritte Diffusat 136, weswegen dieses dem Spülwasser-Aufbereitungsprozess 300 zugeführt wird. Dort kann Kupfer z.B. mittels eines selektiven Ionenaustauschharzes abgetrennt werden.

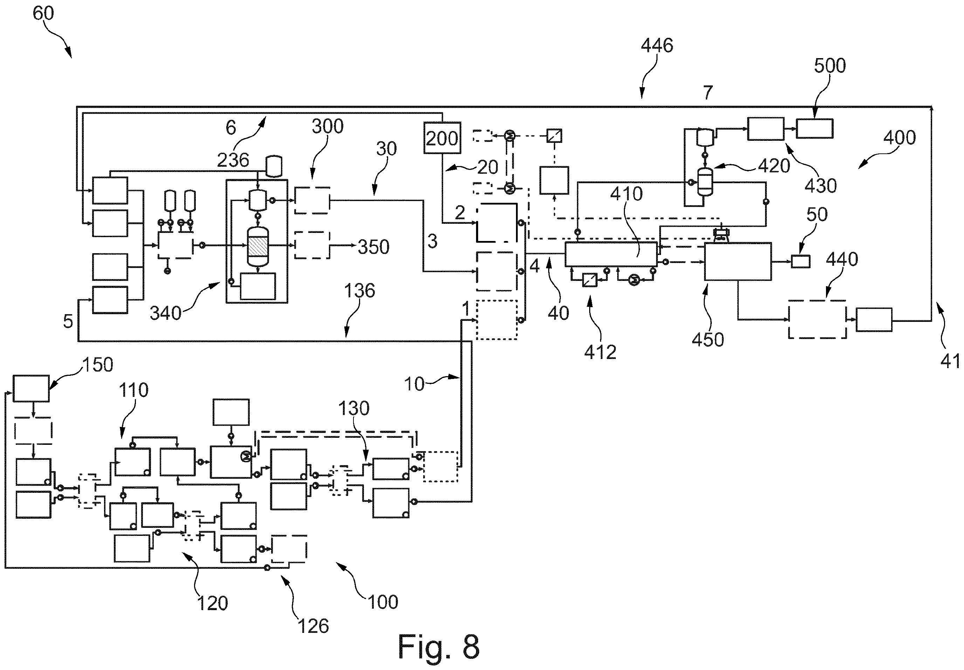

**Figur 8** zeigt eine Übersicht der Aufbereitungsprozesse 100, 200, 300 und des Rückgewinnens 400 bei der Leiterplatten- und/oder Substrat-Herstellung gemäß einem Ausführungsbeispiel der Erfindung. Die Übersicht zeigt die Verzahnung sämtlicher Prozesse ineinander und den sich hieraus ergebenden Wertstoffkreislauf. Die Prozesse wurden für die oben ausgeführten Ausführungsbeispiele jeweils bereits im Detail diskutiert.

**Figur 9** zeigt eine Prozesskontrollvorrichtung 600 zum Regulieren (bzw. Regeln) von zumindest einem Teil des oben beschriebenen Verfahrens (bzw. der Industrieanlage 60) gemäß einem Ausführungsbeispiel der Erfindung. In dem gezeigten Beispiel ist die Prozesskontrollvorrichtung 600 in den ersten Aufbereitungsprozess 100 zum Bereitstellen des ersten Metallsalz-haltigen Mediums 10 aus einem Ätzprozess 150 aus der Leiterplatten- und/oder Substrat-Herstellung implementiert. Auf dieselbe Weise kann die Prozesskontrollvorrichtung 600 auch in die weiteren (oben beschriebenen) Prozesse (bzw. Verfahren) implementiert werden.

Die Prozesskontrollvorrichtung 600 weist auf: i) eine Datenbank 610 zum Erfassen von zumindest einem Prozessparameter 611 aus dem laufenden (im Betriebszustand befindlichen) Prozess (in dem gezeigten Beispiel der erste Aufbereitungsprozess 100). In dem exemplarischen Ausführungsbeispiel ist gezeigt, dass an allen Prozessschritten Prozessparameter (Werte und/oder Bereiche) 611 erfasst werden (z.B. mittels Sensoren) und der Datenbank 610 zugeführt werden. Die Prozessparameter stellen daher "Ist"-Werte dar (z.B. HCl Konzentration, Kupfer Konzentration, Druckdifferenz, etc). Die Prozesskontrollvorrichtung 600 weist ferner auf: ii) eine Datenmodell-Einheit 620, welche eingerichtet ist zum Speichern von zumindest einem vorbestimmten Prozessparameter 621 (Werte und/oder Bereiche). In dem gezeigten Beispiel werden eine Vielzahl von Prozessparametern gemäß einem oder mehr Datenmodellen in der Datenmodell-Einheit 620 für die verschiedenen Prozessschritte bereitgestellt. Diese vorbestimmten Prozessparameter 621 stellen daher "Soll"-Werte dar. Die Prozesskontrollvorrichtung 600 weist ferner auf: iii) eine Berechnungsvorrichtung 630 (z.B. eine einzelne (separate) Einheit oder eine Mehrzahl von Einheiten), welche eingerichtet ist zum a) Vergleichen des erfassten Prozessparameters 611 (bzw. der Mehrzahl dieser Parameter) mit dem vorbestimmten Prozessparameter 621 (bzw. der Mehrzahl dieser Parameter) (z.B. Vergleich "Ist-Wert" gegen "Soll"-Wert), b) Bestimmen einer Steueroperation 631, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation 631 (z.B. Flussrate anpassen).

Gemäß einem exemplarischen Ausführungsbeispiel der (Software-basierten) Prozesskontrollvorrichtung 600 sammelt die Datenbank 610 Daten aus dem laufenden Prozess (Prozessparameter 611) bzw. greift auf Werte aus einem vorgelagerten Prozessschritt (Prozessparameter 611) zu und archiviert daher (alle) "Ist"-Werte. Ein Datenmodell bzw. mehrere voneinander unabhängige Datenmodelle (welche(s) in der Datenmodell-Einheit 620 z.B. ebenfalls in Form einer Datenbank angelegt sind/ist) beinhalten u.a. "Soll"-Werte (bzw. "Soll"-Bereiche), optional auch deren Zusammenhänge und Variablen (z.B. Datenmodelle 621 als Referenzwerte/Referenzmodelle, die zur Überprüfung der "Ist"-Werte 611 herangezogen werden). Die Berechnungsvorrichtung 630 gleicht die "Ist"-Werte mit den "Soll"-Werten (bzw. setzt einen Rechenschritt basierend auf den Datenmodellen 621 in Kombination mit den "Ist"-Werten 611) ab und setzt anschließend eine Aktion (Steueroperation 631) entsprechend dem Abgleichergebnis (z.B. "Ist"-Wert entspricht "Soll"-Wert, "Ist"-Wert weicht von "Soll"-Wert ab, "Ist"-Wert erfüllt bestimmte Kriterien, etc). Die bestimmte Steueroperation 631 kann (zumindest einen Teil) eines Verfahrensschritts wie oben beschrieben aufweisen.

Gemäß einem exemplarischen Ausführungsbeispiel weist die Berechnungsvorrichtung 630 einen selbstlernenden Algorithmus (AI) 625 (z.B. realisiert mittels neuronaler Netzwerke) auf zum Vergleichen und/oder zum Bestimmen. Der selbstlernende Algorithmus 625 ist eingerichtet, die bestimmte Steueroperation 631 automatisch durchzuführen und/oder einem Benutzer zum Überprüfen bereitzustellen. Ferner ist der selbstlernende Algorithmus 625 eingerichtet basierend auf dem Vergleichen einen neuen vorbestimmten Prozessparameter 622 zu bestimmen und diesen automatisch der Datenmodell-Einheit 620 zuzuführen und/oder dem Benutzer zum Überprüfen bereitzustellen. Bevorzugt ist der selbstlernende Algorithmus 625 eingerichtet, das Ergebnis des Überprüfens durch den Benutzer als Lerngrundlage zu verwenden. Gemäß einem exemplarischen Ausführungsbeispiel weist die Berechnungseinheit 630 einen selbstlernenden Algorithmus 625 auf, der Aktionen (Steueroperationen 631) setzt, welche entweder direkt im System implementiert werden oder die dem Operator zur Überprüfung zur Verfügung gestellt werden. Zudem kann die Entscheidung des Operators bei der Überprüfung wiederum die Lerngrundlage für die AI-Funktion bilden. Ferner kann die AI basierend auf den erfassten "Ist"-Werten 611 neue "Soll"-Werte/Bereiche 621 kreieren bzw. vorschlagen, die dann entweder automatisch oder Operator-gesteuert in das Datenmodell übernommen werden.

In einem spezifischen Ausführungsbeispiel werden die folgenden Prozessparameter 611 überwacht bzw. gemessen (im Folgenden angegeben ist jeweils eine beispielhafte Messmethode) und in der Datenbank 610 erfasst:
i) Füllstände; mittels Ultraschallmessungen,
ii) Volumenströme; mittels Flowmeter,
iii) H₂O₂ Konzentration; über das Redoxpotential bestimmt,
iv) Säure Konzentration; pH Wert (in-line) oder Titration (Proben ziehen),
v) Organik Konzentration; photometrisch (in-line) oder Cyclovoltammetrie (Proben ziehen),
vi) Chlorid Konzentration; Titration (Proben ziehen),
vii) Eisen/Kupfer Konzentration; photometrisch oder Dichtemessungen (in-line) oder Titration (Proben ziehen),
viii) Temperatur; Temperatursensoren (in-line),
ix) Differenzdruck bei der Membrandialyse zwischen Diffusat und Dialysat; Drucksensoren (in-line).

In diesem spezifischen Ausführungsbeispiel werden nach dem Vergleichen (bzw. Auswerten, Datenanalyse) der bestimmten (gemessenen) Prozessparameter 611 und der vorbestimmten Prozessparameter 621 durch die Berechnungsvorrichtung 630 mittels der Berechnungsvorrichtung 630 z.B. die folgenden Steueroperationen 631 (bzw. Aktionen) bestimmt und durchgeführt (bzw. getriggert):
i) Chlorgas-Bildung (z.B.: über Gassensoren); Steueroperation: Elektrolyse aus,
ii) zu hohe Peroxidbelastung; Steueroperation: kein Beladen des Ionentauschers zur Aufbereitung der Spülwässer,
iii) zu niedriger Füllstand; Steueroperation: Pumpen aus,
iv) zu hohe Eisenkonzentration im Elektrolyten; Steueroperation: Zuschalten des Ionenaustauschharzes,
v) zu hohe Säure-Konzentration im Elektrolyten; Steueroperation: Zuschalten des Membrandialyse oder Abpumpen der Elektrolysezelle,
vi) geringe Kupfer-Konzentration im Elektrolyten; Steueroperation: Elektrolysezelle abpumpen und Fördern des Elektrolyten zum Vorbehandlungsbecken der Spülwässer,
vii) zu hoher Differenzdruck bei Membrandialyse; Steueroperation: Volumenströme (Flowrate) anpassen,
viii) Kupfer-Konzentration im Permeat des Ionentauschers zur Aufbereitung der Spülwässer; Steueroperation: Regenerieren,
ix) Eisen-Konzentration im Permeat des Ionentauschers zur Eliminierung von Eisen aus den Galvanikabwässer; Steueroperation: Regenerieren,
x) zu hohe Chlorid-Konzentration im Dialysat; Steueroperation: Volumenströme (Flowrate) anpassen.

### Bezugszeichen

1, 2, 3 Erster Teilstrom, zweiter Teilstrom, dritter Teilstrom
4 Gesamtstrom
5, 6, 7 Erster Abtrennstrom, zweiter Abtrennstrom, dritter Abtrennstrom
52 Metall Rückführung zu Ätzprozess
54 Metall Rückführung zu Galvanisierungsprozess
60 Industrieanlage zum Herstellen gedruckter Leiterplatten
100 Aufbereitung eines Metallsalz-haltigen Mediums aus einem Ätzprozess aus der Herstellung gedruckter Leiterplatten
10 Metallsalz-haltiges Medium
11 Aufzubereitendes Medium
15 Säure
15a Erster Teil Säure
15b Zweiter Teil Säure
15c Dritter Teil Säure
110 Erste Membrandialyse
112 Erste Membran
113 Erster Zulauf
115 Erstes Dialysat
116 Erstes Diffusat
120 Zweite Membrandialyse
122 Zweite Membran
123 Zweiter Zulauf
125 Zweites Dialysat
126 Zweites Diffusat
127 Ätzprozess Sammelbecken
130 Dritte Membrandialyse
131 Zulauf für Dialysat
132 Dritte Membran
133 Dritter Zulauf
135 Drittes Dialysat
136 Drittes Diffusat (erster Abtrennstrom)
140 Reaktor, Mischen und Durchführen der chemischen Reaktion
141 Konzentriertes (Säure-freies) aufzubereitendes Medium
143 Weitere Säure
150 Ätzprozess
151 Ätzprozess Überlaufbecken
160 Verdunster
200 Aufbereitung eines Metallsalz-haltigen Mediums aus einem Galvanisierungsprozess aus der Herstellung gedruckter Leiterplatten
20 Metallsalz-haltiges Medium
21 Eisen- und Metallsalz-haltiges Medium
205 Speicher-Modul, Bereitstellen
210 Oxidier-Modul
220 Separier-Modul, Ionentauscher
221 Beladen
222 Regenerieren, Strömen
225 Saure Lösung
226 Eisen-haltige saure Lösung, Regenerat
230 Aufbereiten, Säuredialyse
231 Bereitstellen an Leiterplatten Prozess
235 Eisen-haltiges Dialysat
236 Säure-haltiges Diffusat (zweiter Abtrennstrom)
240 Rückführen Säure
250 Galvanisierungsprozess
300 Aufbereitung eines Metallsalz-haltigen Mediums aus Spülwasser aus der Herstellung gedruckter Leiterplatten
30 Metallsalz-haltiges Medium
31 Aufzubereitendes Medium, Gesamtabtrennstrom
32 Weiteres Spülwasser
305 Bereitstellen
310 Vorbehandeln
311 Behälter Natronlauge, Einstellen pH-Wert
312 Behälter Bisulfit, chemisches Reduzieren
313 Organik-Filter, Aktivkohlefilter
320 Ionentauscher
321 Beladen
322 Regenerieren, Strömen
325 Regeneriermedium, weitere Säure
326 Regeneriermedium, Regenerat
327 Separieren von Abwasser
328 Speicher-Modul für Regenerat
329 Bereitstellen von konzentriertem Medium
340 Separier-Modul
350 Abfall Medium, Wasser mit Einleitqualität
351 Aufreinigung Wasser
352 Zufuhr Wasser
400 Rückgewinnen eines elementaren Metalls aus einem Metallsalz-haltigen Medium aus der Herstellung gedruckter Leiterplatten
40 Metallsalz-haltiges Medium, Elektrolyt
41 Verbrauchter Elektrolyt
50 Elementares Metall (Kupfer)
401 Rückgewinnen erster Teilstrom
402 Rückgewinnen zweiter und dritter Teilstrom
405 Bereitstellen, Zusammenführen, Aufkonzentrieren
410 Versorgungsbecken, Einstellen der Zusammensetzung
412 Aktivkohlefilter, Filtern
414 Temperaturregelung
415 Pumpvorlage für Separieren von Fremdmetall
416 Verdunster, Aufkonzentrieren
419a,b Fluidkommunikation
420 Ionentauscher, Separieren von Fremdmetall
421 Beladen
422 Regenerieren, Strömen
425 Saure Lösung, Regeneriermedium
426 Regenerat, Fremdmetall-haltige saure Lösung, Regeneriermedium
430 Konzentrierte Fremdmetall-haltige saure Lösung
431 Bereitstellen an Leiterplatten Prozess
440 Membrandialyse, Separieren von Säure
441 Zulauf Dialyse
442 Membran
443 Zulauf Diffusat
445 Dialysat mit Metallsalz
446 Diffusat mit Säure (dritter Abtrennstrom)
447 Speicher-Modul Säure
450 Reaktionszelle, Elektrolysezelle
451 Elektrolyse (E-Modul)
452 Oxidation
455 Ablöse-Modul (L-Modul)
460 Luftzirkulation
461 Abluft
462 Zuluft
463 Luftfilter
464 Gesättigte Abluft
465 Natürliche Verdunstung
500 Weiterer Leiterplatten Prozess, Fotolack-Prozess
600 Prozesskontrollvorrichtung
610 Datenbank
611 Prozessparameter, Ist-Wert
620 Datenmodell-Einheit
621 Vorbestimmter Prozessparameter, Soll-Wert
622 Neuer vorbestimmter Prozessparameter
625 Selbstlernender Algorithmus
630 Berechnungsvorrichtung
631 Bestimmte Steueroperation
P Prozessrichtung

## Patentansprüche

1. Ein Verfahren (100) zum Aufbereiten eines aufzubereitenden Mediums (11) aus der Leiterplatten- und/oder Substrat-Herstellung, insbesondere einem Ätzprozess (150), wobei das aufzubereitende Medium (11) ein aufzubereitendes Metallsalz und eine Säure (15) aufweist, das Verfahren aufweisend:
mehrstufiges Entfernen (110, 120) der Säure (15) aus dem aufzubereitenden Medium (11) mittels Membrandialyse, um ein konzentriertes aufzubereitendes Medium (141) bereitzustellen; und nachfolgend
Durchführen einer chemischen Reaktion (140) zum Erzeugen eines Metallsalz-haltigen Mediums (10) aus dem konzentrierten aufzubereitenden Medium (141).

2. Das Verfahren (100) gemäß Anspruch 1, aufweisend zumindest eines der folgenden Merkmale:
wobei das Metallsalz und das aufzubereitende Metallsalz zumindest ein Metall aus der Gruppe aufweisen, welche besteht aus: Kupfer, Nickel, Cobalt, Zinn, Cadmium, Magnesium, Natrium, Silber, Gold;
wobei das aufzubereitende Metallsalz ein Metallchlorid, insbesondere Kupferchlorid, CuCl₂, aufweist;
wobei das Metallsalz ein Metallsulfat, insbesondere Kupfersulfat, CuSO₄, aufweist;
wobei die Säure (15) Salzsäure, HCl, aufweist.

3. Das Verfahren (100) gemäß Anspruch 1 oder 2,
wobei die chemische Reaktion (140) ein Umsalzen aufweist,
insbesondere wobei das Umsalzen ein Umwandeln des aufzubereitenden Metallsalzes in das Metallsalz mittels Zugebens einer weiteren Säure (143) aufweist,
weiter insbesondere wobei die weitere Säure (143) zumindest eine aus der Gruppe aufweist, welche besteht aus: Schwefelsäure, H₂SO₄, Salzsäure, HCl, Salpetersäure, HNO₃, Phosphorsäure, H₃PO₄.

4. Das Verfahren (100) gemäß einem beliebigen der vorhergehenden Ansprüche,
wobei das mehrstufige Entfernen (110, 120) genau zwei Stufen, insbesondere genau zwei Membrandialyse Stufen, aufweist.

5. Das Verfahren (100) gemäß einem beliebigen der vorhergehenden Ansprüche, wobei das Entfernen (110, 120) ferner aufweist:
Entfernen von einem ersten Teil der Säure (15a) aus dem aufzubereitenden Medium (11) mittels einer ersten Membrandialyse (110), um ein erstes Dialysat (115) mit einer ersten Konzentration des aufzubereitenden Metallsalzes und ein erstes Diffusat (116), welches den ersten Teil der Säure (15a) aufweist, mit einer zweiten Konzentration des aufzubereitenden Metallsalzes zu erhalten; und nachfolgend
Entfernen von einem zweiten Teil der Säure (15b) aus dem ersten Diffusat (116) mittels einer zweiten Membrandialyse (120), um ein zweites Dialysat (125) mit einer dritten Konzentration des aufzubereitenden Metallsalzes und ein zweites Diffusat (126), welches den zweiten Teil der Säure (15b) aufweist, mit einer vierten Konzentration des aufzubereitenden Metallsalzes zu erhalten, insbesondere wobei das Entfernen ferner zumindest eines der folgenden Merkmale aufweist:
Bereitstellen des zweiten Diffusats (126), insbesondere welches die Säure (15) aufweist, an einen Ätzprozess (150) bei der Leiterplatten- und/oder Substrat-Herstellung,
insbesondere wobei das zweite Diffusat (126) zunächst aufbereitet wird;
wobei die erste Konzentration gleich oder größer ist als die zweite Konzentration;
wobei die dritte Konzentration größer ist als die vierte Konzentration; und
wobei die dritte Konzentration gleich oder kleiner ist als die zweite Konzentration;
Zusammenführen des ersten Dialysats (115) und des zweiten Dialysats (125), um das konzentrierte aufzubereitende Metallsalz-haltige Medium (141) bereitzustellen.

6. Das Verfahren (100) gemäß einem beliebigen der vorhergehenden Ansprüche, wobei das Durchführen der chemischen Reaktion (140) ferner aufweist:
Erzeugen von Säure (15) in dem Metallsalz-haltigen Medium (10);
zumindest teilweises Durchführen der Reaktion in einer dritten Membrandialyse (130); und
Entfernen von einem dritten Teil der Säure (15c) aus dem Metallsalz-haltigen Medium (10) mittels der dritten Membrandialyse (130), um ein drittes Dialysat (135), welches das Metallsalz aufweist, und ein drittes Diffusat (136), welches den dritten Teil der Säure (15c) aufweist, zu erhalten.

7. Das Verfahren (100) gemäß Anspruch 6,
wobei das Verfahren ferner aufweist:
Bereitstellen des dritten Diffusats (136) als Teilstrom (1) an ein Verfahren (300) zum Aufbereiten eines Metallsalz-haltigen Mediums aus Spülwasser aus der Leiterplatten- und/oder Substrat-Herstellung,
insbesondere wobei das dritte Diffusat (136) mittels eines Ionentauschers (320) aufbereitet wird,
weiter insbesondere wobei der Ionentauscher (320) ein Oxidation-beständiges, insbesondere Wasserstoffperoxid-beständiges, Ionenaustauschharz aufweist.

8. Das Verfahren (100) gemäß einem beliebigen der vorhergehenden Ansprüche, aufweisend zumindest eines der folgenden Merkmale:
Vorgeben eines Maximalwerts für das Volumen des Diffusats-Zulaufs (113, 123, 133) der Membrandialyse (110, 120, 130),
Vorgeben eines Minimalwerts für die Konzentration an aufzubereitendem Metallsalz, und
Steuern der Prozessparameter derart, dass der vorgegebene Maximalwert nicht überschritten wird und der vorgegebene Minimalwert nicht unterschritten wird;
wobei zumindest ein Zulauf des Diffusats (113, 123, 133) der Membrandialyse (110, 120, 130) ein Lösungsmittel, insbesondere entsalztes Wasser, aufweist;
wobei die Membrandialyse (110, 120, 130) einen Durchsatz in dem Bereich 0,5 bis 5 L/hm², insbesondere 1 bis 2 L/hm², aufweist;
wobei das Aufbereiten, insbesondere das Entfernen (110, 120, 130), kontinuierlich betrieben wird;
Entfernen von Wasserstoffperoxid, H₂O₂;
Aufkonzentrieren des Metallsalzes in dem Metallsalz-haltigen Medium (10), insbesondere mittels eines Verdunsters (160);
Rückgewinnen (400) von elementarem Metall (50) aus dem Metallsalz-haltigen Medium (10) in einer Reaktionszelle (450), insbesondere mittels Elektrolyse (451).

9. Das Verfahren gemäß einem beliebigen der vorhergehenden Ansprüche, wobei die chemische Reaktion (140) eine exotherme Reaktion ist, das Verfahren ferner aufweisend:
Ableiten von zumindest einem Teil der Reaktionswärme derart, dass ein flüssiges Medium, insbesondere ein flüssiges Medium in einem Versorgungsbecken oder Elektrolysebecken, innerhalb derselben Leiterplatten- und/oder Substrat-Herstellung erwärmt wird.

10. Eine Vorrichtung (100) zum Aufbereiten eines aufzubereitenden Mediums (11) aus einem Ätzprozess (150) aus der Leiterplatten- und/oder Substrat-Herstellung, wobei das aufzubereitende Medium (11) ein aufzubereitendes Metallsalz und eine Säure (15) aufweist, die Vorrichtung (100) aufweisend:
ein erstes Membrandialyse Modul (110) und in Prozessrichtung (P) nachfolgend ein zweites Membrandialyse Modul (120) zum Entfernen der Säure (15) aus dem aufzubereitenden Medium (11) mittels Membrandialyse, um ein konzentriertes aufzubereitendes Medium (141) bereitzustellen; und in Prozessrichtung (P) nachfolgend
einen Reaktor (140) zum Durchführen einer chemischen Reaktion, um ein Metallsalz-haltigen Mediums (10) aus dem konzentrierten aufzubereitenden Medium (141) zu erzeugen.

11. Die Vorrichtung (100) gemäß Anspruch 10, aufweisend zumindest eines der folgenden Merkmale:
wobei zumindest eine Membran (112, 122, 132) eines Membrandialyse-Moduls (110, 120, 130) eine Wickelmembran oder eine Plattenmembran aufweist;
wobei zumindest eine Membran (112, 122, 132) eines Membrandialyse-Moduls (110, 120, 130) eine Oxidation-beständige, insbesondere eine Wasserstoffperoxid-beständige, Membran (112, 122, 132) aufweist.

12. Verwenden der exothermen chemischen Reaktion (140) von einem Metallchlorid zu einem Metallsulfat oder Metallnitrat oder Metallphosphat zum Erwärmen eines flüssigen Mediums innerhalb einer Leiterplatten- und/oder Substrat-Herstellung.

13. Eine Prozesskontrollvorrichtung (600) zum Regulieren eines Verfahrens gemäß einem beliebigen der Ansprüche 1 bis 9 und/oder einer Vorrichtung gemäß Anspruch 10 oder 11, wobei die Prozesskontrollvorrichtung (600) aufweist:
eine Datenbank (610) zum Erfassen von zumindest einem Prozessparameter (611) aus dem laufenden Prozess;
eine Datenmodell-Einheit (620), welche eingerichtet ist zum Speichern von zumindest einem vorbestimmten Prozessparameter (621); und
eine Berechnungsvorrichtung (630), welche eingerichtet ist zum Vergleichen des erfassten Prozessparameters (611) mit dem vorbestimmten Prozessparameter (621),
Bestimmen einer Steueroperation (631), welche auf dem Ergebnis des Vergleichens basiert, und
Durchführen der bestimmten Steueroperation (631).

14. Die Prozesskontrollvorrichtung (600) gemäß Anspruch 13, ferner aufweisend zumindest eines der folgenden Merkmale:
wobei die Berechnungsvorrichtung (630) einen selbstlernenden Algorithmus (625), insbesondere mittels neuronaler Netzwerke, zum Vergleichen und/oder zum Bestimmen aufweist;
wobei der selbstlernende Algorithmus (625) eingerichtet ist, die bestimmte Steueroperation (631) automatisch durchzuführen, und/oder wobei der selbstlernende Algorithmus (625) eingerichtet ist, die bestimmte Steueroperation (631) einem Benutzer zum Überprüfen bereitzustellen;
wobei der selbstlernende Algorithmus (625) eingerichtet ist basierend auf dem Vergleichen einen neuen vorbestimmten Prozessparameter (622) zu bestimmen und automatisch der Datenmodell-Einheit (620) zuzuführen, und/oder wobei der selbstlernende Algorithmus (625) eingerichtet ist basierend auf dem Vergleichen einen neuen vorbestimmten Prozessparameter (622) zu bestimmen und dem Benutzer zum Überprüfen bereitzustellen;
wobei der selbstlernende Algorithmus (625) eingerichtet ist, das Ergebnis des Überprüfens durch den Benutzer als Lerngrundlage zu verwenden.

15. Ein Computerprogramm-Produkt zum Steuern eines Verfahrens (100) zum Aufbereiten eines aufzubereitenden Mediums (11) aus der Leiterplatten- und/oder Substrat-Herstellung, welches Computerprogramm-Produkt, wenn es von einem oder mehreren Prozessoren ausgeführt wird, das Verfahren nach einem beliebigen der Ansprüche 1 bis 9 und/oder die Vorrichtung nach Anspruch 10 oder 11 und/oder die Prozesskontrollvorrichtung (600) nach Anspruch 13 oder 14 steuert.
